# EUROPEAN PATENT SPECIFICATION

(11) **EP 4 421 206 B1**
(45) Date of publication and mention of the grant of the patent: **09.12.2026**
(21) Application number: 22882640.0
(22) Date of filing: 08.10.2022
(51) Int. Cl.: C23C 4/11, C23C 4/134, C23C 8/12, C23C 14/20, C23C 14/30, C23C 14/16, C23C 14/18, C23C 14/58, C23C 28/00, B64C 1/00, A62C 3/02, A62C 31/12, A62C 31/28, A62C 5/02, A62C 37/00, B64D 1/18, C04B 41/89, C23C 24/04, C09D 5/00

(54) **UNMANNED AERIAL VEHICLE SURFACE COATING, PREPARATION METHOD THEREFOR, AND UNMANNED AERIAL VEHICLE**
OBERFLÄCHENBESCHICHTUNG FÜR UNBEMANNTES LUFTFAHRZEUG, HERSTELLUNGSVERFAHREN DAFÜR UND UNBEMANNTES LUFTFAHRZEUG
REVÊTEMENT DE SURFACE DE VÉHICULE AÉRIEN SANS PILOTE, SON PROCÉDÉ DE PRÉPARATION ET VÉHICULE AÉRIEN SANS PILOTE

(30) Priority: 20.10.2021 CN 202111218199; 20.10.2021 CN 202111218198; 29.10.2021 CN 202111277394; 19.11.2021 CN 202111401595
(43) Date of publication of application: 28.08.2024
(73) Proprietor: Kunming University of Science and Technology, Kunming, Yunnan 650499 (CN)
(72) Inventor: FENG, Jing, Kunming, Yunnan 650499 (CN); CHEN, Lin, Kunming, Yunnan 650499 (CN); CHONG, Xiaoyu, Kunming, Yunnan 650499 (CN); LI, Jianyu, Kunming, Yunnan 650499 (CN); SONG, Jianbo, Kunming, Yunnan 650499 (CN); ZHANG, Luyang, Kunming, Yunnan 650499 (CN); WANG, Jiankun, Kunming, Yunnan 650499 (CN)
(74) Representative: 2K Patent Partnerschaft mbB
(86) International application number: PCT/CN2022/123842
(87) International publication number: WO 2023/066030

(56) References cited:
- CN-A- 106 251 558
- CN-A- 107 512 060
- CN-A- 108 749 029
- CN-A- 111 298 329
- CN-A- 111 908 921
- CN-A- 111 960 837
- CN-A- 113 969 394
- CN-A- 113 981 381
- CN-A- 114 010 983
- CN-A- 114 163 260
- CN-A- 114 164 386
- CN-U- 213 959 127
- JP-A- 2006 117 975
- US-A1- 2018 337 296

## Description

### TECHNICAL FIELD

The disclosure relates to a technical field of material application, and in particular to a UAV surface coating, a preparation method thereof and a UAV.

### BACKGROUND

With the deepening of the research and application of the Unmanned Aerial Vehicle (UAV), its maximum take-off weight has reached more than ten tons. A use of the unmanned low-altitude aerial vehicles at the fire rescue site for fire extinguishing, personnel rescue, communication connections and material delivery and other tasks can effectively reduce the danger of traditional pilots when performing the tasks, at the same time, the unmanned low-altitude aerial vehicles are with small sizes, easy to operate, and have small restrictions on take-off sites when carrying out the fire rescue in a city, which is more suitable for modern development trends. It is necessary to effectively reduce the weight of the aircraft itself, and at the same time increase what it can carry. However, in the prior art, different kinds of resin-based composites or ceramic-based composites are usually used to manufacture the machine body of the low-altitude aircraft. The resin-based composites have the problems of low melting point, insufficient high temperature resistance and easy to be corroded by smoke at the fire site, which leads to failure, thus limiting the applications in large fires scenes and high-temperature fire scenes. While, the ceramic-based composites are silicon carbide fiber-reinforced silicon carbide, carbon fiber-reinforced carbon, carbon fiber-reinforced silicon carbide and silicon carbide fiber-reinforced carbon ceramic-based composites with a melting point of more than 2000 °C, and have advantages of low density, strong plasticity and high specific strength similar to the resin-based composites. However, the disadvantage of the above-mentioned ceramic matrix composites is that they will be oxidized and fail when exposed to air at high temperatures.

In addition, in recent years, fires have occurred frequently in southwest China, forest and grassland areas, the fires have come and developed rapidly, and the losses in areas with large areas of fire are more serious. The traditional fire extinguisher has a significant fire extinguishing effect for the fire of close range or small fire source, and is generally powerless for the fire of long distance and large fire. Moreover, the conventional fire extinguishing UAVs are not very capable of targeted fire-extinguishing at the fire site, and cannot carry out a long-distance, accurate and efficient fire-extinguishing at the fire site.

CN213959127U discloses that: a drone countermeasure directional plate antenna oscillator, comprising an upper cover plate and a lower cover plate. Both sides of the surface of the upper cover plate are penetrated with positioning bolts, and both sides of the bottom of the inner cavity of the lower cover plate are fixedly connected with installation sleeves used in conjunction with the positioning bolts. The inner cavity of the lower cover plate houses the oscillator body, and the surface of the oscillator body is fixedly connected with a protective coating, which includes an anti-oxidation coating and a ceramic wear-resistant coating.

CN108749029A discloses that: conduct surface treatment on the core mold, unseal and clean the foam core mold, and lay a layer of polytetrafluoroethylene film on it to ensure that it is firmly bonded to the foam core mold 1 without overhead; Lay another layer of fiberglass/polytetrafluoroethylene film to form a good and dense working surface. After the paving is completed, perform vacuum pre compaction. The vacuum pre compaction method is to lay a hole isolation film, a breathable felt and a vacuum bag on the foam core mold in turn, form a vacuum system through the adhesion of the sealing tape, and maintain a vacuum degree of more than 0.09 MPa in the system for at least 10 minutes through continuous vacuum pumping, so as to ensure that the paved materials are further bonded with the foam core mold 1. Use special surface treatment materials as intermediate layers to provide good demolding properties and a dense working surface, making the overall fuel tank core mold easy to demold, and the inner wall surface dense and smooth.

US20180337296A1 discloses that: a vehicle skin, such as a composite skin for a UAV wing or other vehicle component, is co-cured with an array of solar cells to form a thin, lightweight, integrated skin structure. In one embodiment, an upper surface of the solar-cell array may be substantially coplanar with an upper surface of the composite skin. A coating, such as a spray-on fluorinated polymer coating, is applied to the upper surface of the integrated skin structure to protect the solar cells from the environment or other potentially harmful elements.

CN107512060A discloses that: a solar-powered unmanned aerial vehicle (UAV) wing skin material and its preparation method. The skin material comprises, from top to bottom, a first wear-resistant layer, a base film layer, an adhesive layer, a fiber support layer, and a second wear-resistant layer. The first and second wear-resistant layers are coatings formed by applying, drying, and curing a coating solution.

### SUMMARY

The disclosure provides a UAV surface coating, a preparation method thereof and the UAV, which mainly solves problems of conventional UAVs with poor high temperature resistance and poor long-distance accurate fire extinguishing capability.

According to the present disclosure, this problem is solved by a UAV surface coating as claimed in claim 1, and by a preparation method thereof as claimed in claim 8. Further advantageous embodiments are the subject-matter of the depend claims.

As mentioned above, the application provides the UAV surface coating, preparation method thereof and UAV, which has the following beneficial effects.

The disclosure uses the lightweight material for the UAV machine body, and the machine body is covered with the coating. The coating at least includes the bonding layer, the antioxidant layer, an oxygen-blocking layer and the heat-insulation cooling layer, which can provide the UAV with effects of thermal insulation and cooling, oxygen propagation resistance and anti-oxidation, and effectively improve an ultimate working temperature and oxidation resistance of the lightweight material, so that the UAV can be used in high-temperature and high-corrosive environments such as fire rescue, realize a low-altitude flight, and extend its duration life. When using the above-mentioned coating as a material of the machine body of the UAV for fire rescue, advantages such as low thermal conductivity and multi-layer structure to improve the thermal insulation and cooling effect can ensure that internal parts of the machine body are under its ultimate service temperature in a service environment of the fire scene, so as to serve effectively for a long time.

### BRIEF DESCRIPTION OF THE DRAWINGS

FIG. 1 is a schematic structural view of a UAV surface coating according to an embodiment of the disclosure.
FIG. 2 is a microstructure view of the UAV surface coating after being insulated at 800°C according to an embodiment of the disclosure.
FIG. 3 is a second schematic structural view of the UAV surface coating according to an embodiment of the disclosure.
FIG. 4 is a third schematic structural view of the UAV surface coating according to an embodiment of the disclosure.
FIG. 5 is a schematic system view of a UAV according to an embodiment of the disclosure.
FIG. 6 is a schematic structural view of a UAV module according to an embodiment of the disclosure.

### DETAILED DESCRIPTION

The following describes the implementation of the disclosure through specific embodiments, and those skilled in the art can easily understand other advantages and effects of the disclosure from the content disclosed in this specification. The disclosure may also be implemented or applied through other different specific embodiments. Various details in this specification may also be modified or changed based on different viewpoints and applications without departing from the disclosure. It should be noted that, the following embodiments and the features in the embodiments can be combined with each other without conflict.

It should be noted that drawings provided in the embodiments are only illustrative of a basic idea of the disclosure. The drawings only show assemblies related to the disclosure instead of drawing according to the number, shape and size of the assemblies in actual implementation. In actual implementation, the type, quantity and ratio of each assembly may be changed at will, and a layout of the assemblies may also be more complicated.

### Embodiment 1:

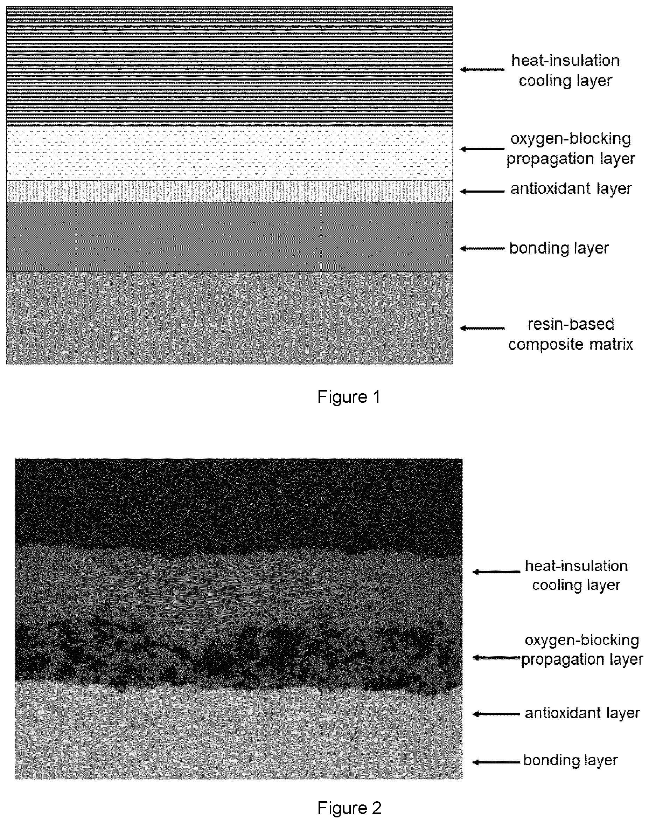

The disclosure provides a UAV surface coating and a preparation method thereof. Please refer to FIG. 1. In an embodiment of the disclosure, the UAV surface coating is coated on a surface of the UAV machine body through a resin-based composite matrix, which is a fiber-reinforced material with organic polymer as the matrix, and a reinforcing fiber is glass fiber. A bonding layer with a thickness of 30µm, an oxygen-blocking propagation layer with a thickness of 50µm, and a heat-insulation cooling layer with a thickness of 1000µm are sequentially prepared on the resin-based composite matrix. Silicon (Si) is used as the bonding layer, LuTa_{0.5}Nb_{0.5}O₄ is used as the oxygen-blocking propagation layer, and ceramic coating of Lu₃Ta_{0.3}Nb_{0.7}O₇ is used as the heat-insulation cooling layer.

Specifically: (1) a silicon (Si) bonding layer with a thickness of 30µm is prepared on a surface of a glass fiber matrix through electron beam physical vapor deposition, in a process of electron beam physical vapor deposition, the silicon (Si) bonding layer is used as a target source, the bonding layer is deposited on the surface of the glass fiber matrix, a temperature of the glass fiber matrix is 350°C, the target-base distance is 300mm, an incident angle is 30°, an accelerating voltage of electrons is 20kV, a vacuum degree is less than 2×10⁻³ Pa, and a deposition rate is 100 nm/min.

(2) The silicon (Si) bonding layer is placed in air for oxidation to obtain a SiO2 antioxidant layer with a thickness of less than 1µm. The oxygen-blocking propagation layer of LuTa_{0.5}Nb_{0.5}O₄ ceramic layer with a thickness of 50µm is prepared by atmospheric plasma spraying on a surface of the antioxidant layer, and LuTa_{0.5}Nb_{0.5}O₄ spherical powder is first prepared through high-temperature solid-phase method by using Lu₂O₃, Nb₂O₅ and Ta₂O₅ as raw materials. Argon is used as protective gas and hydrogen is used as combustion gas in a process of spraying the LuTa_{0.5}Nb_{0.5}O₄ spherical powder through atmospheric plasma spraying by a spraying gun. Wherein, a spraying gun power is 45kW, and a spraying gun distance is 130mm, gas flow rates of the argon and the hydrogen is 45/12slpm and 40/10slpm respectively, a feeding rate is 60g/min, a spraying gun rate is 200mm/s, and a spraying time is 2min.

(3) A reflective heat insulation layer with Lu₃Ta_{0.3}Nb_{0.7}O₇ ceramic coating with a thickness of 1000µm is prepared through atmospheric plasma spraying on a surface of the ceramic oxygen-blocking propagation layer of LuTa_{0.5}Nb_{0.5}O₄, and Lu₃Ta_{0.3}Nb_{0.7}O₇ spherical powder is prepared through the high-temperature solid-phase method by using Lu₂O₃, Nb₂O₅ and Ta₂O₅ as raw materials. The Argon is used as the protective gas and the hydrogen is used as the combustion gas in the process of spraying the Lu₃Ta_{0.3}Nb_{0.7}O₇ spherical powder through atmospheric plasma spraying by the spraying gun. Wherein, the spraying gun power is 43kW, and the spraying gun distance is 140mm, the gas flow rates of the argon and the hydrogen is 42/12slpm and 45/15slpm respectively, the feeding rate is 50g/min, the spraying gun rate is 100mm/s, and the spraying time is 20min.

### Embodiment 2:

The disclosure provides the UAV surface coating and the preparation method thereof. Please refer to FIG. 1. In an embodiment of the disclosure, the UAV surface coating is coated on the surface of the UAV machine body through the resin-based composite matrix, which is the fiber-reinforced material with organic polymer as the matrix, and the reinforcing fiber is carbon fiber. The bonding layer with the thickness of 100µm, the oxygen-blocking propagation layer with the thickness of 75µm, and the heat-insulation cooling layer with the thickness of 100µm are sequentially prepared on the resin-based composite matrix. Aluminum (Al) is used as the bonding layer, Tm_{1/4}Yb_{1/4}Lu_{1/4}Sc_{1/4}Ta_{0.8}Nb_{0.2}O₄ is used as the oxygen-blocking propagation layer, and ceramic coating of Y₃Ta_{0.5}Nb_{0.5}O₇ is used as the heat-insulation cooling layer.

Specifically: (1) an aluminum (Al) bonding layer with the thickness of 100µm is prepared on the surface of a glass fiber matrix through electron beam physical vapor deposition, in the process of electron beam physical vapor deposition, the aluminum (Al) bonding layer is used as the target source, the bonding layer is deposited on the surface of the matrix, the temperature of the matrix is 350°C, the target-base distance is 300mm, the incident angle is 30°, the accelerating voltage of electrons is 20kV, the vacuum degree is less than 2×10⁻³ Pa, and the deposition rate is 100 nm/min.

(2) The aluminum (Al) bonding layer is placed in the air for oxidation to obtain an Al₂O₃ antioxidant layer with a thickness of less than 1µm. The oxygen-blocking propagation layer of Tm_{1/4}Yb_{1/4}Lu_{1/4}Sc_{1/4}Ta_{0.8}Nb_{0.2}O₄ ceramic layer with a thickness of 75µm is prepared by atmospheric plasma spraying on the surface of the antioxidant layer. Tm_{1/4}Yb_{1/4}Lu_{1/4}Sc_{1/4}Ta_{0.8}Nb_{0.2}O₄ spherical powder is first prepared through high-temperature solid-phase method by using Sc₂O₃, Tm₂O₃, Yb₂O₃, Lu₂O₃, Nb₂O₅ and Ta₂O₅ as raw materials. The argon is used as the protective gas and the hydrogen is used as the combustion gas in a process of spraying the Tm_{1/4}Yb_{1/4}Lu_{1/4}Sc_{1/4}Ta_{0.8}Nb_{0.2}O₄ spherical powder through atmospheric plasma spraying by the spraying gun. Wherein, the spraying gun power is 45kW, and the spraying gun distance is 130mm, the gas flow rates of the argon and the hydrogen is 45/12slpm and 40/10slpm respectively, the feeding rate is 60g/min, the spraying gun rate is 200mm/s, and the spraying time is 20min.

(3) A reflective heat insulation layer with Y₃Ta_{0.5}Nb_{0.5}O₇ ceramic coating with a thickness of 100µm is prepared through atmospheric plasma spraying on a surface of the ceramic oxygen-blocking propagation layer of Tm_{1/4}Yb_{1/4}Lu_{1/4}Sc_{1/4}Ta_{0.8}Nb_{0.2}O₄. Y₃Ta_{0.5}Nb_{0.5}O₇ spherical powder is prepared through the high-temperature solid-phase method by using Y₂O₃, Nb₂O₅ and Ta₂O₅ as raw materials. The argon is used as the protective gas and the hydrogen is used as the combustion gas in a process of spraying the Lu₃Ta_{0.3}Nb_{0.7}O₇ spherical powder through atmospheric plasma spraying by the spraying gun. Wherein, the spraying gun power is 43kW, and the spraying gun distance is 140mm, the gas flow rates of the argon and the hydrogen is 42/12slpm and 45/15slpm respectively, the feeding rate is 50g/min, the spraying gun rate is 100mm/s, and the spraying time is 2min.

### Embodiment 3:

The disclosure provides the UAV surface coating and the preparation method thereof. Please refer to FIG. 1. In an embodiment of the disclosure, the UAV surface coating is coated on the surface of the UAV machine body through the resin-based composite matrix, which is the fiber-reinforced material with organic polymer as the matrix, and the reinforcing fiber is basalt fiber. The bonding layer with the thickness of 50µm, the oxygen-blocking propagation layer with the thickness of 80µm, and the heat-insulation cooling layer with the thickness of 600µm are sequentially prepared on the resin-based composite matrix. Tantalum niobium molybdenum alloy is used as the bonding layer, YTa_{0.5}Nb_{0.5}O₄ is used as the oxygen-blocking propagation layer, and ceramic coating of YGdDyTa_{0.5}Nb_{0.5}O₇ is used as the heat-insulation cooling layer.

Specifically: (1) a tantalum niobium molybdenum alloy bonding layer with the thickness of 50µm is prepared on the surface of a glass fiber matrix through electron beam physical vapor deposition, in the process of electron beam physical vapor deposition, the tantalum niobium molybdenum alloy bonding layer is used as the target source, the bonding layer is deposited on the surface of the matrix, the temperature of the matrix is 350°C, the target-base distance is 300mm, the incident angle is 30°, the accelerating voltage of electrons is 20kV, the vacuum degree is less than 2×10⁻³ Pa, and the deposition rate is 100 nm/min.

(2) The tantalum niobium molybdenum alloy bonding layer is placed in the air for oxidation to obtain the corresponding oxide antioxidant layer with the thickness of less than 1µm. The oxygen-blocking propagation layer of YTa_{0.5}Nb_{0.5}O₄ ceramic layer with a thickness of 75µm is prepared by atmospheric plasma spraying on the surface of the antioxidant layer, and YTa_{0.5}Nb_{0.5}O₄ spherical powder is first prepared through the high-temperature solid-phase method by using Y₂O₃, Nb₂O₅ and Ta₂O₅ as raw materials. The argon is used as the protective gas and the hydrogen is used as the combustion gas in a process of spraying the YTa_{0.5}Nb_{0.5}O₄ spherical powder through atmospheric plasma spraying by the spraying gun. Wherein, the spraying gun power is 45kW, and the spraying gun distance is 130mm, the gas flow rates of the argon and the hydrogen is 45/12slpm and 40/10slpm respectively, the feeding rate is 60g/min, the spraying gun rate is 200mm/s, and the spraying time is 2min.

(3) A reflective heat insulation layer with YGdDyTa_{0.5}Nb_{0.5}O₇ ceramic coating with a thickness of 600µm is prepared through atmospheric plasma spraying on a surface of the ceramic oxygen-blocking propagation layer of YTa_{0.5}Nb_{0.5}O₄. YGdDyTa_{0.5}Nb_{0.5}O_{y} spherical powder is prepared through the high-temperature solid-phase method by using Dy₂O₃, Gd₂O₃, Y₂O₃, Nb₂O₅ and Ta₂O₅ as raw materials. The argon is used as the protective gas and the hydrogen is used as the combustion gas in a process of spraying the YGdDyTa_{0.5}Nb_{0.5}O₇ spherical powder through atmospheric plasma spraying by the spraying gun. Wherein, the spraying gun power is 43kW, and the spraying gun distance is 140mm, the gas flow rates of the argon and the hydrogen is 42/12slpm and 45/15slpm respectively, the feeding rate is 50g/min, the spraying gun rate is 100mm/s, and the spraying time is 12min.

### Embodiment 4:

The disclosure provides the UAV surface coating and the preparation method thereof. Please refer to FIG. 1. In an embodiment of the disclosure, the UAV surface coating is coated on the surface of the UAV machine body through the resin-based composite matrix, which is the fiber-reinforced material with organic polymer as the matrix, and the reinforcing fiber is aramid fiber. The bonding layer with the thickness of 60µm, the oxygen-blocking propagation layer with the thickness of 60µm, and the heat-insulation cooling layer with the thickness of 720µm are sequentially prepared on the resin-based composite matrix. Zirconium-silicon alloy is used as the bonding layer, SmTa_{0.2}Nb_{0.8}O₄ is used as the oxygen-blocking propagation layer, and ceramic coating of SmEuGdTa_{0.2}Nb_{0.8}O₇ is used as the heat-insulation cooling layer.

Specifically: (1) a zirconium-silicon alloy bonding layer with the thickness of 50µm is prepared on the surface of the glass fiber matrix through electron beam physical vapor deposition, in the process of electron beam physical vapor deposition, the zirconium-silicon alloy bonding layer is used as the target source, the bonding layer is deposited on the surface of the matrix, the temperature of the matrix is 350°C, the target-base distance is 300mm, the incident angle is 30°, the accelerating voltage of electrons is 20kV, the vacuum degree is less than 2×10⁻³ Pa, and the deposition rate is 100 nm/min.

(2) The zirconium-silicon alloy bonding layer is placed in the air for oxidation to obtain the corresponding oxide antioxidant layer with the thickness of less than 1µm. The oxygen-blocking propagation layer of SmTa_{0.2}Nb_{0.8}O₄ ceramic layer with a thickness of 60µm is prepared by atmospheric plasma spraying on the surface of the antioxidant layer, and SmTa_{0.2}Nb_{0.8}O₄ spherical powder is first prepared through the high-temperature solid-phase method by using Sm₂O₃, Nb₂O₅ and Ta₂O₅ as raw materials. The argon is used as the protective gas and the hydrogen is used as the combustion gas in a process of spraying the SmTa_{0.2}Nb_{0.8}O₄ spherical powder through atmospheric plasma spraying by the spraying gun. Wherein, the spraying gun power is 45kW, and the spraying gun distance is 130mm, the gas flow rates of the argon and the hydrogen is 45/12slpm and 40/10slpm respectively, the feeding rate is 60g/min, the spraying gun rate is 200mm/s, and the spraying time is 2min.

(3) A reflective heat insulation layer with SmEuGdTa_{0.2}Nb_{0.8}O₇ ceramic coating with a thickness of 720µm is prepared through atmospheric plasma spraying on a surface of the ceramic oxygen-blocking propagation layer of SmEuGdTa_{0.2}Nb_{0.8}O₇. SmEuGdTa_{0.2}Nb_{0.8}O₇ spherical powder is prepared through the high-temperature solid-phase method by using Sm₂O₃, Gd₂O₃, Eu₂O₃, Nb₂O₅ and Ta₂O₅ as raw materials. The argon is used as the protective gas and the hydrogen is used as the combustion gas in a process of spraying the SmEuGdTa_{0.2}Nb_{0.8}O₇ spherical powder through atmospheric plasma spraying by the spraying gun. Wherein, the spraying gun power is 43kW, and the spraying gun distance is 140mm, the gas flow rates of the argon and the hydrogen is 42/12slpm and 45/15slpm respectively, the feeding rate is 50g/min, the spraying gun rate is 100mm/s, and the spraying time is 15min.

### Embodiment 5:

The disclosure provides the UAV surface coating and the preparation method thereof. Please refer to FIG. 1. In an embodiment of the disclosure, the UAV surface coating is coated on a surface of the UAV machine body through a resin-based composite matrix, which is a fiber-reinforced material with organic polymer as the matrix, and a reinforcing fiber is glass fiber. The bonding layer with a thickness of 30µm, the oxygen-blocking propagation layer with a thickness of 50µm, and the heat-insulation cooling layer with a thickness of 500µm are sequentially prepared on the resin-based composite matrix. The silicon (Si) is used as the bonding layer, the LuTa_{0.5}Nb_{0.5}O₄ is used as the oxygen-blocking propagation layer, and the ceramic coating of Lu₃Ta_{0.3}Nb_{0.7}O₇ is used as the heat-insulation cooling layer.

Specifically: (1) the silicon (Si) bonding layer with the thickness of 30µm is prepared on the surface of the glass fiber matrix through electron beam physical vapor deposition, in the process of electron beam physical vapor deposition, the silicon (Si) bonding layer is used as the target source, the bonding layer is deposited on the surface of the glass fiber matrix, the temperature of the glass fiber matrix is 350°C, the target-base distance is 300mm, the incident angle is 30°, the accelerating voltage of electrons is 20kV, the vacuum degree is less than 2×10⁻³Pa, and the deposition rate is100 nm/min.

(2) The silicon (Si) bonding layer is placed in air for oxidation to obtain the SiO2 antioxidant layer with the thickness of less than 1µm. The oxygen-blocking propagation layer of LuTa_{0.5}Nb_{0.5}O₄ ceramic layer with the thickness of 50µm is prepared by atmospheric plasma spraying on the surface of the antioxidant layer, and LuTa_{0.5}Nb_{0.5}O₄ spherical powder is first prepared through high-temperature solid-phase method by using Lu₂O₃, Nb₂O₅ and Ta₂O₅ as raw materials. The argon is used as the protective gas and the hydrogen is used as the combustion gas in the process of spraying the LuTa_{0.5}Nb_{0.5}O₄ spherical powder through atmospheric plasma spraying by the spraying gun. Wherein, the spraying gun power is 45kW, and the spraying gun distance is 130mm, the gas flow rates of the argon and the hydrogen is 45/12slpm and 40/10slpm respectively, the feeding rate is 60g/min, the spraying gun rate is 200mm/s, and the spraying time is 2min.

(3) A reflective heat insulation layer with Lu₃Ta_{0.3}Nb_{0.7}O₇ ceramic coating with the thickness of 500µm is prepared through atmospheric plasma spraying on the surface of the ceramic oxygen-blocking propagation layer of LuTa_{0.5}Nb_{0.5}O₄. Lu₃Ta_{0.3}Nb_{0.7}O₇ spherical powder is prepared through the high-temperature solid-phase method by using Lu₂O₃, Nb₂O₅ and Ta₂O₅ as raw materials. The Argon is used as the protective gas and the hydrogen is used as the combustion gas in the process of spraying the Lu₃Ta_{0.3}Nb_{0.7}O₇ spherical powder through atmospheric plasma spraying by the spraying gun. Wherein, the spraying gun power is 43kW, and the spraying gun distance is 140mm, the gas flow rates of the argon and the hydrogen is 42/12slpm and 45/15slpm respectively, the feeding rate is 50g/min, the spraying gun rate is 100mm/s, and the spraying time is 10min.

### Embodiment 6:

The disclosure provides the UAV surface coating and the preparation method thereof. Please refer to FIG. 1. In an embodiment of the disclosure, the UAV surface coating is coated on the surface of the UAV machine body through the resin-based composite matrix, which is the fiber-reinforced material with organic polymer as the matrix, and the reinforcing fiber is carbon fiber. The bonding layer with the thickness of 100µm, the oxygen-blocking propagation layer with the thickness of 75µm, and the heat-insulation cooling layer with the thickness of 500µm are sequentially prepared on the resin-based composite matrix. The aluminum (Al) is used as the bonding layer, the Tm_{1/4}Yb_{1/4}Lu_{1/4}Sc_{1/4}Ta_{0.8}Nb_{0.2}O₄ is used as the oxygen-blocking propagation layer, and the ceramic coating of Y₃Ta_{0.5}Nb_{0.5}O₇ is used as the heat-insulation cooling layer.

Specifically: (1) the aluminum (Al) bonding layer with the thickness of 100µm is prepared on the surface of the glass fiber matrix through electron beam physical vapor deposition, in the process of electron beam physical vapor deposition, the aluminum (Al) bonding layer is used as the target source, the bonding layer is deposited on the surface of the matrix, the temperature of the matrix is 350°C, the target-base distance is 300mm, the incident angle is 30°, the accelerating voltage of electrons is 20kV, the vacuum degree is less than 2×10⁻³ Pa, and the deposition rate is 100 nm/min.

(2) The aluminum (Al) bonding layer is placed in the air for oxidation to obtain the Al₂O₃ antioxidant layer with the thickness of less than 1µm. The oxygen-blocking propagation layer of Tm_{1/4}Yb_{1/4}Lu_{1/4}Sc_{1/4}Ta_{0.8}Nb_{0.2}O₄ ceramic layer with the thickness of 75µm is prepared by atmospheric plasma spraying on the surface of the antioxidant layer. The Tm_{1/4}Yb_{1/4}Lu_{1/4}Sc_{1/4}Ta_{0.8}Nb_{0.2}O₄ spherical powder is first prepared through high-temperature solid-phase method by using Sc₂O₃, Tm₂O₃, Yb₂O₃, Lu₂O₃, Nb₂O₅ and Ta₂O₅ as raw materials. The argon is used as the protective gas and the hydrogen is used as the combustion gas in a process of spraying the Tm_{1/4}Yb_{1/4}Lu_{1/4}Sc_{1/4}Ta_{0.8}Nb_{0.2}O₄ spherical powder through atmospheric plasma spraying by the spraying gun. Wherein, the spraying gun power is 45kW, and the spraying gun distance is 130mm, the gas flow rates of the argon and the hydrogen is 45/12slpm and 40/10slpm respectively, the feeding rate is 60g/min, the spraying gun rate is 200mm/s, and the spraying time is 20min.

(3) The reflective heat insulation layer with Y₃Ta_{0.5}Nb_{0.5}O₇ ceramic coating with the thickness of 500µm is prepared through atmospheric plasma spraying on a surface of the ceramic oxygen-blocking propagation layer of Tm_{1/4}Yb_{1/4}Lu_{1/4}Sc_{1/4}Ta_{0.8}Nb_{0.2}O₄. Y₃Ta_{0.5}Nb_{0.5}O₇ spherical powder is prepared through the high-temperature solid-phase method by using Y₂O₃, Nb₂O₅ and Ta₂O₅ as raw materials. The argon is used as the protective gas and the hydrogen is used as the combustion gas in the process of spraying the Lu₃Ta_{0.3}Nb_{0.7}O₇ spherical powder through atmospheric plasma spraying by the spraying gun. Wherein, the spraying gun power is 43kW, and the spraying gun distance is 140mm, the gas flow rates of the argon and the hydrogen is 42/12slpm and 45/15slpm respectively, the feeding rate is 50g/min, the spraying gun rate is 100mm/s, and the spraying time is 10min.

### Comparative embodiment 1:

The disclosure provides the UAV surface coating and the preparation method thereof. Please refer to FIG. 1. In an embodiment of the disclosure, the UAV surface coating is coated on the surface of the UAV machine body through the resin-based composite matrix, which is the fiber-reinforced material with organic polymer as the matrix, and the reinforcing fiber is glass fiber. The bonding layer with the thickness of 30µm and the oxygen-blocking propagation layer with the thickness of 50µm are sequentially prepared on the resin-based composite matrix. The silicon (Si) is used as the bonding layer, and the LuTa_{0.5}Nb_{0.5}O₄ is used as the oxygen-blocking propagation layer.

Specifically: (1) the silicon (Si) bonding layer with the thickness of 30µm is prepared on the surface of the glass fiber matrix through electron beam physical vapor deposition, in the process of electron beam physical vapor deposition, the silicon (Si) bonding layer is used as the target source, the bonding layer is deposited on the surface of the glass fiber matrix, the temperature of the glass fiber matrix is 350°C, the target-base distance is 300mm, the incident angle is 30°, the accelerating voltage of electrons is 20kV, the vacuum degree is less than 2×10⁻³Pa, and the deposition rate is 100nm/min.

(2) The silicon (Si) bonding layer is placed in air for oxidation to obtain the SiO2 antioxidant layer with the thickness of less than 1µm. The oxygen-blocking propagation layer of LuTa_{0.5}Nb_{0.5}O₄ ceramic layer with the thickness of 50µm is prepared by atmospheric plasma spraying on the surface of the antioxidant layer, and the LuTa_{0.5}Nb_{0.5}O₄ spherical powder is first prepared through high-temperature solid-phase method by using Lu₂O₃, Nb₂O₅ and Ta₂O₅ as raw materials. The argon is used as the protective gas and the hydrogen is used as the combustion gas in the process of spraying the LuTa_{0.5}Nb_{0.5}O₄ spherical powder through atmospheric plasma spraying by the spraying gun. Wherein, the spraying gun power is 45kW, and the spraying gun distance is 130mm, the gas flow rates of the argon and the hydrogen is 45/12slpm and 40/10slpm respectively, the feeding rate is 60g/min, the spraying gun rate is 200mm/s, and the spraying time is 2min.

### Comparative embodiment 2:

The disclosure provides the UAV surface coating and the preparation method thereof. Please refer to FIG. 1. In an embodiment of the disclosure, the UAV surface coating is coated on the surface of the UAV machine body through the resin-based composite matrix, which is the fiber-reinforced material with organic polymer as the matrix, and the reinforcing fiber is carbon fiber. The oxygen-blocking propagation layer with the thickness of 75µm, and the heat-insulation cooling layer with the thickness of 500µm are sequentially prepared on the resin-based composite matrix. The aluminum (Al) is used as the bonding layer, the Tm_{1/4}Yb_{1/4}Lu_{1/4}Sc_{1/4}Ta_{0.8}Nb_{0.2}O₄ is used as the oxygen-blocking propagation layer, and the ceramic coating Of Y₃Ta_{0.5}Nb_{0.5}O₇ is used as the heat-insulation cooling layer.

Specifically: (1) The oxygen-blocking propagation layer of Tm_{1/4}Yb_{1/4}Lu_{1/4}Sc_{1/4}Ta_{0.8}Nb_{0.2}O₄ ceramic layer with the thickness of 75µm is prepared by atmospheric plasma spraying on a surface of the matrix. The Tm_{1/4}Yb_{1/4}Lu_{1/4}Sc_{1/4}Ta_{0.8}Nb_{0.2}O₄ spherical powder is first prepared through high-temperature solid-phase method by using Sc₂O₃, Tm₂O₃, Yb₂O₃, Lu₂O₃, Nb₂O₅ and Ta₂O₅ as raw materials. The argon is used as the protective gas and the hydrogen is used as the combustion gas in a process of spraying the Tm_{1/4}Yb_{1/4}Lu_{1/4}Sc_{1/4}Ta_{0.8}Nb_{0.2}O₄ spherical powder through atmospheric plasma spraying by the spraying gun. Wherein, the spraying gun power is 45kW, and the spraying gun distance is 130mm, the gas flow rates of the argon and the hydrogen is 45/12slpm and 40/10slpm respectively, the feeding rate is 60g/min, the spraying gun rate is 200mm/s, and the spraying time is 20min.

(2) The reflective heat insulation layer with Y₃Ta_{0.5}Nb_{0.5}O₇ ceramic coating with the thickness of 500µm is prepared through atmospheric plasma spraying on a surface of the ceramic oxygen-blocking propagation layer of Tm_{1/4}Yb_{1/4}Lu_{1/4}Sc_{1/4}Ta_{0.8}Nb_{0.2}O₄. Y₃Ta_{0.5}Nb_{0.5}O₇ spherical powder is prepared through the high-temperature solid-phase method by using Y₂O₃, Nb₂O₅ and Ta₂O₅ as raw materials. The argon is used as the protective gas and the hydrogen is used as the combustion gas in the process of spraying the Lu₃Ta_{0.3}Nb_{0.7}O₇ spherical powder through atmospheric plasma spraying by the spraying gun. Wherein, the spraying gun power is 43kW, and the spraying gun distance is 140mm, the gas flow rates of the argon and the hydrogen is 42/12slpm and 45/15slpm respectively, the feeding rate is 50g/min, the spraying gun rate is 100mm/s, and the spraying time is 10min.

A composition of a material system prepared in the above embodiments 1-6 and the comparative embodiments 1-2 is shown in Table 1, and a softening temperature and a heat insulation cooling gradient of the material are tested. A test process is to heat a material coating surface, and a temperature of a coating surface and a temperature of an interface between the matrix and the coating are tested. A temperature when a resin-based composite material softens and separates from the coating is determined as the softening temperature, and a temperature difference between the coating surface and the interface during softening is the thermal insulation cooling gradient. The original softening temperatures of the resin-based materials reinforced by the glass fiber, the carbon fiber, the basalt fiber and the aramid fiber used in the disclosure are 140°C, 145°C, 120°C and 94°C, respectively.

**Table 1**

| | reinforcing fiber | bonding layer | oxygen-blocking propagation layer | heat-insulation cooling layer |
|---|---|---|---|---|
| Embodiment 1: | glass fiber | 30µm-Si | 50µm | 1000µm |
| | | | LuTa_{0.5}Nb_{0.5}O₄ | Lu₃Ta_{0.3}Nb_{0.7}O₇ |
| Embodiment 2: | carbon fiber | 100µm-Al | 75µm | 100µm |
| | | | Tm_{1/4}Yb_{1/4}Lu_{1/4}Sc_{1/4} Ta_{0.8}Nb_{0.2}O₄ | Y₃Ta_{0.5}Nb_{0.5}O₇ |
| Embodiment 3: | basalt fiber | 50µm-TaNbMo | 80µm | 600µm |
| | | | YTa_{0.5}Nb_{0.5}O₄ | YGdDyTa_{0.5}Nb_{0.5}O₇ |
| Embodiment 4: | aramid fiber | 60µm-ZrSi | 60µm | 720µm |
| | | | SmTa_{0.2}Nb_{0.8}O₄ | SmEuGdTa_{0.2}Nb_{0.8}O₇ |
| Embodiment 5: | glass fiber | 30µm-Si | 100µm | 500µm |
| | | | LuTa_{0.5}Nb_{0.5}O₄ | Lu₃Ta_{0.3}Nb_{0.7}O₇ |
| Embodiment 6: | carbon fiber | 100µm-Al | 75µm | 500µm |
| | | | Tm_{1/4}Yb_{1/4}Lu_{1/4}Sc_{1/4} Ta_{0.8}Nb_{0.2}O₄ | Y₃Ta_{0.5}Nb_{0.5}O₇ |
| Comparative embodiment 1: | glass fiber | 30µm-Si | 100µm | - |
| | | | LuTa_{0.5}Nb_{0.5}O₄ | |
| Comparative embodiment 2: | carbon fiber | - | 75µm | 500µm |
| | | | Tm_{1/4}Yb_{1/4}Lu_{1/4}Sc_{1/4}Ta_{0.8}Nb_{0.2}O₄ | Y₃Ta_{0.5}Nb_{0.5}O₇ |

**Table 2**

| | heat insulation cooling gradient (°C) | softening temperature (°C) |
|---|---|---|
| Embodiment 1: | 592 | 732 |
| Embodiment 2: | 210 | 355 |
| Embodiment 3: | 341 | 461 |
| Embodiment 4: | 406 | 500 |
| Embodiment 5: | 308 | 448 |
| Embodiment 6: | 487 | 632 |
| Comparative embodiment 1: | 52 | 192 |
| Comparative embodiment 2: | 200 | 345 |

Table 2 shows that a gradient coating prepared for different types of resin-based composite material can provide excellent thermal insulation protection properties and increase its working temperature by 100°C to 600°C, while a coating without a gradient composite coating as the preparation of the disclosure can also improve a certain thermal insulation cooling gradient, but the performance is obviously insufficient. In addition, when the binder layer was not prepared in the comparative embodiment 2, it is found that the coating material is peeled off after two thermal cycles, while thermal cycle life of other materials exceeded 20 times. Please refer to FIG. 2. FIG. 2 is a microstructure view of a prepared composite gradient coating after a heat preservation at 800°C, and a tight bonding between layers proved that a binding force of the coating is strong and there were no obvious cracks and pores.

### Embodiment 7:

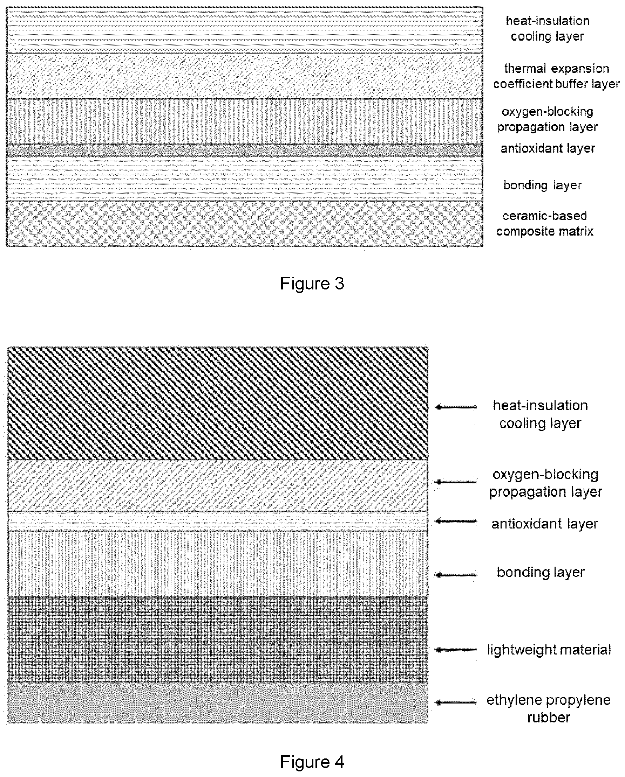

The disclosure provides the UAV surface coating and the preparation method thereof. Please refer to FIG. 3. In an embodiment of the disclosure, the UAV surface coating is coated on the surface of the UAV machine body through the ceramic-based composite matrix, which is made of silicon carbide fiber-reinforced silicon carbide. The bonding layer with the thickness of 100µm, the antioxidant layer with a thickness less than 1µm, the oxygen-blocking propagation layer with the thickness of 30µm, the thermal expansion coefficient buffer layer with the thickness of 30µm and the heat-insulation cooling layer with the thickness of 100µm are sequentially deposited on the silicon carbide fiber-reinforced silicon carbide matrix. Tantalum (Ta) is used as the bonding layer. The oxygen-blocking propagation layer is made of rare earth tantalate ceramic material of RETaO₄, wherein, RE is Yb, and the thermal expansion coefficient buffer layer is made of ceramic of RETa₃O₉, wherein, RE is Tm.

Specifically: (1) a tantalum (Ta) bonding layer with the thickness of 100µm is prepared on a surface of the silicon carbide fiber-reinforced silicon carbide matrix through cold spraying. In a process of cold spraying, compressed nitrogen is used as working gas. A spraying pressure is 0.66MPa, a spraying distance is 30mm, a spraying temperature is 800°C, and a powder feeding rate is 40g/min. After the material coated with the tantalum bonding layer is placed in the air, an oxidation of the tantalum may form an antioxidant layer of dense tantalum oxide Ta₂O₅ with a thickness less than 1µm on its surface.

(2) The oxygen-blocking propagation layer of YbTaO₄ ceramic material with a thickness of 35µm is prepared by atmospheric plasma spraying on a surface of the antioxidant layer of dense tantalum oxide Ta₂O₅. YbTaO₄ spherical powder is first prepared through high-temperature solid-phase method by usingYb₂O₃ and Ta₂O₅ as raw materials. The argon is used as the protective gas and the hydrogen is used as the combustion gas in a process of spraying the oxygen-blocking propagation layer through atmospheric plasma spraying. Wherein, during the spraying, the spraying gun power is 42kW, and the spraying gun distance is 100mm, the gas flow rates of the argon and the hydrogen is 40/12slpm and 45/10slpm respectively, the feeding rate is 50g/min, the spraying gun rate is 300mm/s, and the spraying time is 1min.

(3) The thermal expansion coefficient buffer layer with TmTa₃O₉ ceramic coating with the thickness of 30µm is prepared through atmospheric plasma spraying on a surface of the ceramic oxygen-blocking propagation layer of YbTaO₄. TmTa₃O₉ spherical powder is first prepared through the high-temperature solid-phase method by using Tm₂O₃ and Ta₂O₅ as raw materials. The argon is used as the protective gas and the hydrogen is used as the combustion gas in the process of spraying thermal expansion coefficient buffer layer through atmospheric plasma spraying. Wherein, the spraying gun power is 46kW, and the spraying gun distance is 150mm, the gas flow rates of the argon and the hydrogen is 42/12slpm and 40/10slpm respectively, the feeding rate is 30g/min, the spraying gun rate is 300mm/s, and the spraying time is 2min.

(4) A heat-insulation cooling layer with Tm₃TaO₇ ceramic coating with the thickness of 200µm is prepared through atmospheric plasma spraying on a surface of the ceramic thermal expansion coefficient buffer layer of TmTa₃O₉. Tm₃TaO₇ spherical powder is first prepared through high-temperature solid-phase method by using Tm₂O₃ and Ta₂O₅ as raw materials. The argon is used as the protective gas and the hydrogen is used as the combustion gas in a process of spraying the heat-insulation cooling layer through atmospheric plasma spraying. Wherein, the spraying gun power is 46kW, and the spraying gun distance is 150mm, the gas flow rates of the argon and the hydrogen is 42/12slpm and 40/10slpm respectively, the feeding rate is 30g/min, the spraying gun rate is 300mm/s, and the spraying time is 2min.

### Embodiment 8:

The disclosure provides the UAV surface coating and the preparation method thereof. Please refer to FIG. 3. In an embodiment of the disclosure, the UAV surface coating is coated on the surface of the UAV machine body through the ceramic-based composite matrix, which is made of silicon carbide fiber-reinforced silicon carbide. The bonding layer with the thickness of 200µm, the antioxidant layer with the thickness less than 1µm, the oxygen-blocking propagation layer with the thickness of 50µm, the thermal expansion coefficient buffer layer with the thickness of 50µm and the heat-insulation cooling layer with the thickness of 100µm are sequentially deposited on the silicon carbide fiber-reinforced carbon matrix. The tantalum (Ta) is used as the bonding layer. The oxygen-blocking propagation layer is made of rare earth tantalate ceramic coating of RETaO₄, wherein, RE is Yb and Lu, and the thermal expansion coefficient buffer layer is made of ceramic of RETa₃O₉, wherein, RE is La, Ho and Tm.

Specifically: (1) a tantalum bonding layer with the thickness of 200µm is prepared on a surface of the silicon carbide fiber-reinforced silicon carbide matrix through cold spraying. In a process of cold spraying, compressed nitrogen is used as working gas. A spraying pressure is 0.66MPa, a spraying distance is 30mm, a spraying temperature is 800°C, and a powder feeding rate is 40g/min. After the material coated with the tantalum bonding layer is placed in the air, an oxidation of the tantalum may form an antioxidant layer of dense tantalum oxide Ta₂O₅ with a thickness less than 1µm on its surface.

(2) The oxygen-blocking propagation layer of Yb_{1/2}Lu_{1/2}TaO₄ ceramic coating with the thickness of 50µm is prepared by atmospheric plasma spraying on the surface of the antioxidant layer of dense tantalum oxide Ta₂O₅. Yb_{1/2}Lu_{1/2}TaO₄ spherical powder is first prepared through high-temperature solid-phase method by using Lu₂O₃, Yb₂O₃ and Ta₂O₅ as raw materials. The argon is used as the protective gas and the hydrogen is used as the combustion gas in the process of spraying the oxygen-blocking propagation layer through atmospheric plasma spraying. Wherein, during the spraying, the spraying gun power is 42kW, and the spraying gun distance is 100mm, the gas flow rates of the argon and the hydrogen is 40/12slpm and 45/10slpm respectively, the feeding rate is 50g/min, the spraying gun rate is 300mm/s, and the spraying time is 2min.

(3) The thermal expansion coefficient buffer layer with La_{1/3}Ho_{1/3}Tm_{1/3}Ta₃O₉ ceramic coating with the thickness of 50µm is prepared through atmospheric plasma spraying on a surface of the ceramic oxygen-blocking propagation layer of Yb_{1/2}Lu_{1/2}TaO₄. La_{1/3}Ho_{1/3}Tm_{1/3}Ta₃O₉ spherical powder is first prepared through the high-temperature solid-phase method by using La₂O₃, Ho₂O₃, Tm₂O₃ and Ta₂O₅ as raw materials. The argon is used as the protective gas and the hydrogen is used as the combustion gas in the process of spraying the thermal expansion coefficient buffer layer through atmospheric plasma spraying. Wherein, the spraying gun power is 46kW, and the spraying gun distance is 150mm, the gas flow rates of the argon and the hydrogen is 42/12slpm and 40/10slpm respectively, the feeding rate is 30g/min, the spraying gun rate is 300mm/s, and the spraying time is 3min.

(4) A heat-insulation cooling layer with Y₃TaO₇ ceramic coating with the thickness of 100µm is prepared through atmospheric plasma spraying on a surface of the ceramic thermal expansion coefficient buffer layer of La_{1/3}Ho_{1/3}Tm_{1/3}Ta₃O₉. Y₃TaO₇ spherical powder is first prepared through high-temperature solid-phase method by using Y₂O₃ and Ta₂O₅ as raw materials. The argon is used as the protective gas and the hydrogen is used as the combustion gas in a process of spraying the heat-insulation cooling ceramic layer through atmospheric plasma spraying. Wherein, the spraying gun power is 46kW, and the spraying gun distance is 150mm, the gas flow rates of the argon and the hydrogen is 42/12slpm and 40/10slpm respectively, the feeding rate is 30g/min, the spraying gun rate is 300mm/s, and the spraying time is 2min.

### Embodiment 9:

The disclosure provides the UAV surface coating and the preparation method thereof. Please refer to FIG. 3. In an embodiment of the disclosure, the UAV surface coating is coated on the surface of the UAV machine body through the ceramic-based composite matrix, which is made of carbon fiber-reinforced silicon carbide. The bonding layer with the thickness of 150µm, the antioxidant layer with the thickness less than 1µm, the oxygen-blocking propagation layer with the thickness of 35µm, the thermal expansion coefficient buffer layer with the thickness of 35µm and the heat-insulation cooling layer with the thickness of 1000µm are sequentially deposited on the carbon fiber-reinforced silicon carbide matrix. The tantalum (Ta) is used as the bonding layer. The oxygen-blocking propagation layer is made of rare earth tantalate ceramic coating of RETaO₄, wherein, RE is Sc, and the thermal expansion coefficient buffer layer is made of ceramic of RETa₃O₉, wherein, RE is La.

Specifically: (1) a tantalum bonding layer with the thickness of 150µm is prepared on a surface of the silicon carbide fiber-reinforced silicon carbide matrix through cold spraying. In a process of cold spraying, compressed nitrogen is used as working gas. A spraying pressure is 0.66MPa, a spraying distance is 30mm, a spraying temperature is 800°C, and a powder feeding rate is 40g/min. After the material coated with the tantalum bonding layer is placed in the air, an oxidation of the tantalum may form an antioxidant layer of dense tantalum oxide Ta₂O₅ with a thickness less than 1µm on its surface.

(2) The oxygen-blocking propagation layer of ScTaO₄ ceramic coating with a thickness of 35µm is prepared by atmospheric plasma spraying on the surface of the antioxidant layer of dense tantalum oxide Ta₂O₅. ScTaO₄ spherical powder is first prepared through high-temperature solid-phase method by using Sc₂O₃ and Ta₂O₅ as raw materials. The argon is used as the protective gas and the hydrogen is used as the combustion gas in the process of spraying the oxygen-blocking propagation layer through atmospheric plasma spraying. Wherein, during the spraying, the spraying gun power is 42kW, and the spraying gun distance is 100mm, the gas flow rates of the argon and the hydrogen is 40/12slpm and 45/10slpm respectively, the feeding rate is 50g/min, the spraying gun rate is 300mm/s, and the spraying time is 2min.

(3) The thermal expansion coefficient buffer layer with LaTa₃O₉ ceramic coating with the thickness of 30µm is prepared through atmospheric plasma spraying on a surface of the ceramic oxygen-blocking propagation layer of ScTaO₄. LaTa₃O₉ spherical powder is first prepared through the high-temperature solid-phase method by using La₂O₃ and Ta₂O₅ as raw materials. The argon is used as the protective gas and the hydrogen is used as the combustion gas in the process of spraying the thermal expansion coefficient buffer layer through atmospheric plasma spraying. Wherein, the spraying gun power is 46kW, and the spraying gun distance is 150mm, the gas flow rates of the argon and the hydrogen is 42/12slpm and 40/10slpm respectively, the feeding rate is 30g/min, the spraying gun rate is 300mm/s, and the spraying time is 3min.

(4) A heat-insulation cooling layer with YLaDyTaO₇ ceramic coating with the thickness of 1000µm is prepared through atmospheric plasma spraying on a surface of the ceramic thermal expansion coefficient buffer layer of LaTa₃O₉. YLaDyTaO₇ spherical powder is first prepared through high-temperature solid-phase method by using Y₂O₃, La₂O₃, Dy₂O₃ and Ta₂O₅ as raw materials. The argon is used as the protective gas and the hydrogen is used as the combustion gas in the process of spraying the heat-insulation cooling ceramic layer through atmospheric plasma spraying. Wherein, the spraying gun power is 46kW, and the spraying gun distance is 150mm, the gas flow rates of the argon and the hydrogen is 42/12slpm and 40/10slpm respectively, the feeding rate is 30g/min, the spraying gun rate is 300mm/s, and the spraying time is 10min.

### Embodiment 10:

The disclosure provides the UAV surface coating and the preparation method thereof. Please refer to FIG. 3. In an embodiment of the disclosure, the UAV surface coating is coated on the surface of the UAV machine body through the ceramic-based composite matrix, which is made of carbon fiber-reinforced carbon. The bonding layer with the thickness of 170µm, the antioxidant layer with the thickness less than 1µm, the oxygen-blocking propagation layer with the thickness of 35µm, the thermal expansion coefficient buffer layer with the thickness of 40µm and the heat-insulation cooling layer with the thickness of 500µm are sequentially deposited on the carbon fiber-reinforced carbon matrix. The tantalum (Ta) is used as the bonding layer. The oxygen-blocking propagation layer is made of rare earth tantalate ceramic coating of RETaO₄, wherein, RE is Sc, Yb and Lu, and the thermal expansion coefficient buffer layer is made of ceramic of RETa₃O₉, wherein, RE is La, Ho, Er and Tm.

Specifically: (1) the tantalum bonding layer with the thickness of 170µm is prepared on the surface of the silicon carbide fiber-reinforced silicon carbide matrix through cold spraying. In the process of cold spraying, the compressed nitrogen is used as the working gas. The spraying pressure is 0.66MPa, the spraying distance is 30mm, the spraying temperature is 800°C, and the powder feeding rate is 40g/min. After the material coated with the tantalum bonding layer is placed in the air, the oxidation of the tantalum may form the antioxidant layer of dense tantalum oxide Ta₂O₅ with the thickness less than 1µm on its surface.

(2) The oxygen-blocking propagation layer of Sc_{1/3}Yb_{1/3}Lu_{1/3}TaO₄ ceramic coating with the thickness of 35µm is prepared by atmospheric plasma spraying on the surface of the antioxidant layer of dense tantalum oxide Ta₂O₅. Sc_{1/3}Yb_{1/3}Lu_{1/3}TaO₄ spherical powder is first prepared through high-temperature solid-phase method by using Sc₂O₃, Lu₂O₃, Yb₂O₃ and Ta₂O₅ as raw materials. The argon is used as the protective gas and the hydrogen is used as the combustion gas in the process of spraying the oxygen-blocking propagation layer through atmospheric plasma spraying. Wherein, during the spraying, the spraying gun power is 42kW, and the spraying gun distance is 100mm, the gas flow rates of the argon and the hydrogen is 40/12slpm and 45/10slpm respectively, the feeding rate is 50g/min, the spraying gun rate is 300mm/s, and the spraying time is 2min.

(3) The thermal expansion coefficient buffer layer with La_{1/4}Ho_{1/4}Tm_{1/4}Er_{1/4}Ta₃O₉ ceramic coating with the thickness of 40µm is prepared through atmospheric plasma spraying on a surface of the ceramic oxygen-blocking propagation layer of Sc_{1/3}Yb_{1/3}Lu_{1/3}TaO₄. La_{1/4}Ho_{1/4}Tm_{1/4}Er_{1/4}Ta₃O₉ spherical powder is first prepared through the high-temperature solid-phase method by using Er₂O₃, La₂O₃, Ho₂O₃, Tm₂O₃ and Ta₂O₅ as raw materials. The argon is used as the protective gas and the hydrogen is used as the combustion gas in the process of spraying the thermal expansion coefficient buffer layer through atmospheric plasma spraying. Wherein, the spraying gun power is 46kW, and the spraying gun distance is 150mm, the gas flow rates of the argon and the hydrogen is 42/12slpm and 40/10slpm respectively, the feeding rate is 30g/min, the spraying gun rate is 300mm/s, and the spraying time is 3min.

(4) A heat-insulation cooling layer with Y₃TaO₇ ceramic coating with the thickness of 500µm is prepared through atmospheric plasma spraying on a surface of the ceramic thermal expansion coefficient buffer layer of La_{1/4}Ho_{1/4}Tm_{1/4}Er_{1/4}Ta₃O₉. The Y₃TaO₇ spherical powder is first prepared through high-temperature solid-phase method by using Y₂O₃ and Ta₂O₅ as raw materials. The argon is used as the protective gas and the hydrogen is used as the combustion gas in the process of spraying the heat-insulation cooling ceramic layer through atmospheric plasma spraying. Wherein, the spraying gun power is 46kW, and the spraying gun distance is 150mm, the gas flow rates of the argon and the hydrogen is 42/12slpm and 40/10slpm respectively, the feeding rate is 30g/min, the spraying gun rate is 300mm/s, and the spraying time is 10min.

### Comparative embodiment 3:

The disclosure provides the UAV surface coating and the preparation method thereof. Please refer to FIG. 1. In an embodiment of the disclosure, the UAV surface coating is coated on the surface of the UAV machine body through the ceramic-based composite matrix, which is made of silicon carbide fiber-reinforced carbon. The bonding layer with the thickness of 200µm, the antioxidant layer with the thickness less than 1µm, the oxygen-blocking propagation layer with the thickness of 50µm and the heat-insulation cooling layer with the thickness of 100µm are sequentially deposited on the silicon carbide fiber-reinforced carbon matrix. The tantalum (Ta) is used as the bonding layer. The oxygen-blocking propagation layer is made of rare earth tantalate ceramic coating of RETaO₄, wherein, RE is Yb and Lu, and the thermal expansion coefficient buffer layer is made of ceramic of RETa₃O₉, wherein, RE is La, Ho and Tm.

Specifically: (1) the tantalum bonding layer with the thickness of 200µm is prepared on the surface of the silicon carbide fiber-reinforced silicon carbide matrix through cold spraying. In the process of cold spraying, the compressed nitrogen is used as the working gas. The spraying pressure is 0.66MPa, the spraying distance is 30mm, the spraying temperature is 800°C, and the powder feeding rate is 40g/min. After the material coated with the tantalum bonding layer is placed in the air, the oxidation of the tantalum may form the antioxidant layer of dense tantalum oxide Ta₂O₅ with the thickness less than 1µm on its surface.

(2) The oxygen-blocking propagation layer of Yb_{1/2}Lu_{1/2}TaO₄ ceramic coating with the thickness of 50µm is prepared by atmospheric plasma spraying on the surface of the antioxidant layer of dense tantalum oxide Ta₂O₅. Yb_{1/2}Lu_{1/2}TaO₄ spherical powder is first prepared through high-temperature solid-phase method by using Lu₂O₃, Yb₂O₃ and Ta₂O₅ as raw materials. The argon is used as the protective gas and the hydrogen is used as the combustion gas in the process of spraying the oxygen-blocking propagation layer through atmospheric plasma spraying. Wherein, during the spraying, the spraying gun power is 42kW, and the spraying gun distance is 100mm, the gas flow rates of the argon and the hydrogen is 40/12slpm and 45/10slpm respectively, the feeding rate is 50g/min, the spraying gun rate is 300mm/s, and the spraying time is 2min.

(3) The heat-insulation cooling layer with Y₃TaO₇ ceramic coating with the thickness of 100µm is prepared through atmospheric plasma spraying on a surface of the oxygen-blocking propagation layer of Yb_{1/2}Lu_{1/2}TaO₄ ceramic coating. The Y₃TaO₇ spherical powder is first prepared through high-temperature solid-phase method by using Y₂O₃ and Ta₂O₅ as raw materials. The argon is used as the protective gas and the hydrogen is used as the combustion gas in the process of spraying the heat-insulation cooling ceramic layer through atmospheric plasma spraying. Wherein, the spraying gun power is 46kW, and the spraying gun distance is 150mm, the gas flow rates of the argon and the hydrogen is 42/12slpm and 40/10slpm respectively, the feeding rate is 30g/min, the spraying gun rate is 300mm/s, and the spraying time is 2min.

### Comparative embodiment 4:

The disclosure provides the UAV surface coating and the preparation method thereof. Please refer to FIG. 3. In an embodiment of the disclosure, the UAV surface coating is coated on the surface of the UAV machine body through the ceramic-based composite matrix, which is made of carbon fiber-reinforced silicon carbide. The oxygen-blocking propagation layer with the thickness of 35µm, the thermal expansion coefficient buffer layer with the thickness of 35µm and the heat-insulation cooling layer with the thickness of 1000µm are sequentially deposited on the carbon fiber-reinforced silicon carbide matrix. The tantalum (Ta) is used as the bonding layer. The oxygen-blocking propagation layer is made of rare earth tantalate ceramic coating of RETaO₄, wherein, RE is Sc, and the thermal expansion coefficient buffer layer is made of ceramic of RETa₃O₉, wherein, RE is La.

Specifically: (1) The oxygen-blocking propagation layer of ScTaO₄ ceramic coating with the thickness of 35µm is prepared by atmospheric plasma spraying on the surface of the matrix. The ScTaO₄ spherical powder is first prepared through high-temperature solid-phase method by using Sc₂O₃ and Ta₂O₅ as raw materials. The argon is used as the protective gas and the hydrogen is used as the combustion gas in the process of spraying the oxygen-blocking propagation layer through atmospheric plasma spraying. Wherein, during the spraying, the spraying gun power is 42kW, and the spraying gun distance is 100mm, the gas flow rates of the argon and the hydrogen is 40/12slpm and 45/10slpm respectively, the feeding rate is 50g/min, the spraying gun rate is 300mm/s, and the spraying time is 2min.

(2) The thermal expansion coefficient buffer layer with LaTa₃O₉ ceramic coating with the thickness of 35µm is prepared through atmospheric plasma spraying on the surface of the ceramic oxygen-blocking propagation layer of ScTaO₄. The LaTa₃O₉ spherical powder is first prepared through the high-temperature solid-phase method by using La₂O₃ and Ta₂O₅ as raw materials. The argon is used as the protective gas and the hydrogen is used as the combustion gas in the process of spraying the thermal expansion coefficient buffer layer through atmospheric plasma spraying. Wherein, the spraying gun power is 46kW, and the spraying gun distance is 150mm, the gas flow rates of the argon and the hydrogen is 42/12slpm and 40/10slpm respectively, the feeding rate is 30g/min, the spraying gun rate is 300mm/s, and the spraying time is 3min.

(3) A heat-insulation cooling layer with YLaDyTaO₇ ceramic coating with the thickness of 1000µm is prepared through atmospheric plasma spraying on a surface of the ceramic thermal expansion coefficient buffer layer of LaTa₃O₉. YLaDyTaO₇ spherical powder is first prepared through high-temperature solid-phase method by using Y₂O₃, La₂O₃, Dy₂O₃ and Ta₂O₅ as raw materials. The argon is used as the protective gas and the hydrogen is used as the combustion gas in the process of spraying the heat-insulation cooling ceramic layer through atmospheric plasma spraying. Wherein, the spraying gun power is 46kW, and the spraying gun distance is 150mm, the gas flow rates of the argon and the hydrogen is 42/12slpm and 40/10slpm respectively, the feeding rate is 30g/min, the spraying gun rate is 300mm/s, and the spraying time is 10min.

A specific composition of a material system prepared in the above embodiments 7-10 is shown in Table 3. In order to characterize a performance of the embodiments and comparative embodiments, a number of thermal cycles required for failure, an oxidation weight loss rate and the heat insulation cooling gradient are tested. Wherein, a thermal cycling test process is to use a flame to heat the coating surface to 1000°C and keep the temperature for 3 minutes, and then cool it for 2 minutes. This cycle continues until the coating peels off or a material oxidizes and loses more than 10% weight. After weighing a mass of the material system before (W1) and after (W2) the total number of thermal cycles, the oxidation weight loss rate is (W1-W2)/W1×100%. While a temperature difference between the coating surface and a contact interface between the matrix and the coating during a first test is a heat insulation cooling gradient of the coating material, and results are shown in Table 4.

**Table 3**

| | matrix | bonding layer | oxygen-blocking propagation layer | buffer layer | heat-insulation cooling layer |
|---|---|---|---|---|---|
| Embodiment 1 | SiC_{f}/SiC | 100µm | 30µm YbTaO₄ | 30µm TmTa₃O₉ | 200µm Tm₃TaO₇ |
| Embodiment 2 | SiC_{f}/SiC | 200µm | 50µm Yb_{1/2}Lu_{1/2}TaO₄ | 50µm La_{1/3}Ho_{1/3}Tm_{1/3}Ta₃ O₉ | 100µm Y₃TaO₇ |
| Embodiment 3 | C_{f}/SiC | 150µm | 35µm ScTaO₄ | 35µm LaTa₃O₉ | 1000µm YLaDyTaO₇ |
| Embodiment 4 | C_{f}/C | 170µm | 35µm SC_{1/3}Yb_{1/3}Lu_{1/3}TaO₄ | 40µm La_{1/4}Ho_{1/4}Tm_{1/4}Er_{1/4}Ta₃O₉ | 500µm Y₃TaO₇ |
| Comparative embodiment 1: | SiC_{f}/C | 200µm | 50µm Yb_{1/2}Lu_{1/2}TaO₄ | - | 100µm Y₃TaO₇ |
| Comparative embodiment 2: | C_{f}/SiC | - | 35µm ScTaO₄ | 35µm LaTa₃O₉ | 1000µm YLaDyTaO₇ |

**Table 4**

| | number of thermal cycles | oxidation weight loss rate | heat insulation cooling gradient (°C) |
|---|---|---|---|
| Embodiment 1 | 303 | 12 | 482 |
| Embodiment 2 | 317 | 15 | 409 |
| Embodiment 3 | 1352 | 10 | 627 |
| Embodiment 4 | 1068 | 13 | 516 |
| Comparative embodiment 1: | 23 | 26 | 388 |
| Comparative embodiment 2: | 16 | 22 | 611 |

The test results show that the materials with a complete coating system have excellent thermal insulation and cooling effect, and can be used for a long time in a temperature environment of 1000°C, which prevents an oxidation failure of the above-mentioned matrix materials. While the materials without a complete coating system fail early due to a large difference in thermal expansion coefficient and weak adhesion, so they cannot meet the service requirements.

### Embodiment 11:

Please refer to FIG. 4. In this embodiment, lightweight material for manufacturing the UAV machine body is selected from carbon fiber braid. Internal parts of the UAV and a carbon fiber braided machine body are combined by ethylene propylene rubber. A specific production process is that the ethylene propylene rubber is covered on a surface of the UAV, and then a lightweight material casing of the UAV machine body may be buckled on its surface. The carbon fiber braid material is used as the matrix, a coating including "bonding layer, antioxidant layer, oxygen-blocking propagation layer and heat-insulation cooling layer" is prepared on a matrix surface, and the specific operations are as follows:
(1)the silicon (Si) bonding layer with the thickness of 50µm is prepared on a surface of the carbon fiber braid through electron beam physical vapor deposition. In a process of the deposition, the substrate temperature is 350°C, the target-base distance is 300mm, the incident angle is 30°, the accelerating voltage of electrons is 20kV, the vacuum degree is less than 2×10⁻³Pa, and the deposition rate is 100nm/min.
(2)After a Si coating is prepared, it is placed in the air and heated at 300°C for oxidation to obtain a SiO₂ coating with a thickness of 10µm, which means the antioxidant layer.
(3)An oxygen-blocking propagation layer of YbTaO4 ceramic coating with a thickness of 50µm is prepared on a surface of the antioxidant layer through atmospheric plasma spraying. The YbTaO₄ spherical powder is first prepared through high-temperature solid-phase method by using Yb₂O₃ and Ta₂O₅ as raw materials. Then, the YbTaO₄ ceramic coating is prepared through atmospheric plasma spraying with the YbTaO₄ spherical powder, and process parameters of the atmospheric plasma spraying are as follows: the spraying gun power is 42kW, and the spraying gun distance is 120mm, the gas flow rates of the argon and the hydrogen is 40/12slpm and 45/10slpm respectively, the feeding rate is 45g/min, the spraying gun rate is 200mm/s, and the spraying time is 2min.
(4)A heat-insulation cooling layer with La₃NbO₇ ceramic coating with a thickness of 300µm is prepared through atmospheric plasma spraying on the surface of the oxygen-blocking propagation layer. La₃NbO₇ spherical powder is first prepared through the high-temperature solid-phase method by using La₂O₃ and Nb₂O₅ as raw materials. Then, the La₃NbO₇ ceramic coating is prepared through atmospheric plasma spraying with the La₃NbO₇ spherical powder, and process parameters of the atmospheric plasma spraying are as follows: the spraying gun power is 43kW, and the spraying gun distance is 120mm, the gas flow rates of the argon and the hydrogen is 42/12slpm and 45/15slpm respectively, the feeding rate is 50g/min, the spraying gun rate is 100mm/s, and the spraying time is 10min.

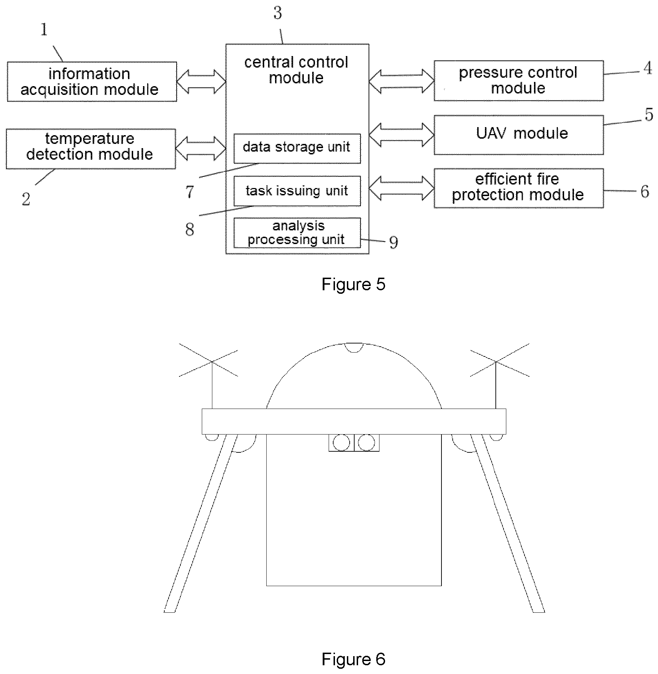

Please refer to FIG. 5. FIG. 5 shows a thermal conductivity of the coating system (excluding ethylene propylene rubber) prepared on the surface of the lightweight material carbon fiber braid provided in this embodiment with the temperature, and the thermal conductivity increases slightly with an increase of the temperature, but an overall thermal conductivity of the material system is extremely low. The overall thermal conductivity between 0.32W/m/K and 0.48W/m/K is proved that it has excellent thermal insulation protection in a high temperature environment.

Please refer to FIG. 6. FIG. 6 shows a microstructure view of the coating system prepared in the embodiment. Wherein the antioxidant layer is very thin and only a black part area on a surface of the bonding layer. It may also be seen from FIG. 3 that a combination of materials between the coatings is tight, and there is no obvious crack existing, which proves that the coating material with extremely strong binding force can be obtained by adopting a preparation process of the disclosure.

### Embodiment 12:

Please refer to FIG. 4. In this embodiment, the lightweight material for manufacturing the UAV machine body is selected from TC4 titanium alloy material. The TC4 titanium alloy material is used as the matrix, the coating including "bonding layer, antioxidant layer, oxygen-blocking propagation layer and heat-insulation cooling layer" is prepared on the matrix surface, and the specific operations are as follows:
(1)the aluminum (Al) bonding layer with the thickness of 50µm is prepared on a surface of the TC4 titanium alloy through electron beam physical vapor deposition. In the process of the deposition, the substrate temperature is 400°C, the target-base distance is 300mm, the incident angle is 45°, the accelerating voltage of electrons is 22kV, the vacuum degree is less than 3×10⁻³Pa, and the deposition rate is 100nm/min.
(2)After an Al coating is prepared, it is placed in the air and heated at 100°C for oxidation to obtain an Al₂O₃ coating with a thickness less than 10µm, which means the antioxidant layer.
(3)An oxygen-blocking propagation layer of AlTaO₄ ceramic coating with a thickness of 50µm is prepared on a surface of the antioxidant layer through atmospheric plasma spraying. The Yb_{0.5}Lu_{0.5}TaO₄ spherical powder is first prepared through high-temperature solid-phase method by using Lu₂O₃, Yb₂O₃ and Ta₂O₃ as raw materials. Then, Yb_{0.5}Lu_{0.5}TaO₄ ceramic coating is prepared through atmospheric plasma spraying with the Yb_{0.5}Lu_{0.5}TaO₄ spherical powder, and process parameters of the atmospheric plasma spraying are as follows: the spraying gun power is 42kW, and the spraying gun distance is 120mm, the gas flow rates of the argon and the hydrogen is 40/12slpm and 45/10slpm respectively, the feeding rate is 45g/min, the spraying gun rate is 200mm/s, and the spraying time is 2min.
(4)A heat-insulation cooling layer with Y₃NbO₇ ceramic coating with a thickness of 350µm is prepared through atmospheric plasma spraying on the surface of the oxygen-blocking propagation layer. Y₃NbO₇ spherical powder is first prepared through the high-temperature solid-phase method by using Y₂O₃ and Nb₂O₅ as raw materials. Then, the Y₃NbO₇ ceramic coating is prepared through atmospheric plasma spraying with the Y₃NbO₇ spherical powder, and process parameters of the atmospheric plasma spraying are as follows: the spraying gun power is 43kW, and the spraying gun distance is 100mm, the gas flow rates of the argon and the hydrogen is 42/12slpm and 45/15slpm respectively, the feeding rate is 40g/min, the spraying gun rate is 100mm/s, and the spraying time is 11min.

### Embodiment 13:

Please refer to FIG. 4. In this embodiment, the lightweight material for manufacturing the UAV machine body is selected from aluminum alloy. The aluminum alloy is used as the matrix, the coating including "bonding layer, antioxidant layer, oxygen-blocking propagation layer and heat-insulation cooling layer" is prepared on the matrix surface, and the specific operations are as follows:
(1)the aluminum (Al) bonding layer with the thickness of 20µm is prepared on a surface of the aluminum alloy through electron beam physical vapor deposition. In the process of the deposition, the substrate temperature is 400°C, the target-base distance is 300mm, the incident angle is 45°, the accelerating voltage of electrons is 22kV, the vacuum degree is less than 3×10⁻³Pa, and the deposition rate is 100nm/min.
(2)After the Al coating is prepared, it is placed in the air and heated at 100°C for oxidation to obtain an Al₂O₃ coating with the thickness less than 10µm, which means the antioxidant layer.
(3)An oxygen-blocking propagation layer of AlTaO₄ ceramic coating with a thickness of 100µm is prepared on the surface of the antioxidant layer through atmospheric plasma spraying. AlTaO₄ spherical powder is first prepared through high-temperature solid-phase method by using Al₂O₃ and Ta₂O₅ as raw materials. Then, the AlTaO₄ ceramic coating is prepared through atmospheric plasma spraying with the AlTaO₄ spherical powder, and process parameters of the atmospheric plasma spraying are as follows: the spraying gun power is 42kW, and the spraying gun distance is 120mm, the gas flow rates of the argon and the hydrogen is 40/12slpm and 45/10slpm respectively, the feeding rate is 45g/min, the spraying gun rate is 200mm/s, and the spraying time is 5min.
(4)A heat-insulation cooling layer with Sm₃NbO₇ ceramic coating with a thickness of 600µm is prepared through atmospheric plasma spraying on the surface of the oxygen-blocking propagation layer. Sm₃NbO₇ spherical powder is first prepared through the high-temperature solid-phase method by using Sm₂O₃ and Nb₂O₅ as raw materials. Then, the Sm₃NbO₇ ceramic coating is prepared through atmospheric plasma spraying with the Sm₃NbO₇ spherical powder, and process parameters of the atmospheric plasma spraying are as follows: the spraying gun power is 43kW, and the spraying gun distance is 100mm, the gas flow rates of the argon and the hydrogen is 42/12slpm and 45/15slpm respectively, the feeding rate is 40g/min, the spraying gun rate is 100mm/s, and the spraying time is 20min.

### Embodiment 14:

Please refer to FIG. 4. In this embodiment, the lightweight material for manufacturing the UAV machine body is selected from the aluminum alloy. The aluminum alloy is used as the matrix, the coating including "bonding layer, antioxidant layer, oxygen-blocking propagation layer and heat-insulation cooling layer" is prepared on the matrix surface, and the specific operations are as follows:
(1)a tantalum (Ta) bonding layer with the thickness of 100µm is prepared on the surface of the aluminum alloy through electron beam physical vapor deposition. In the process of the deposition, the substrate temperature is 400°C, the target-base distance is 300mm, the incident angle is 45°, the accelerating voltage of electrons is 22kV, the vacuum degree is less than 3×10⁻³Pa, and the deposition rate is 100nm/min.
**(2)After** the tantalum coating is prepared, it is placed in the air and heated at 30°C for oxidation to obtain a Ta₂O₅ coating with the thickness less than 10µm, which means the antioxidant layer.
**(3)An** oxygen-blocking propagation layer of YTaO₄ ceramic coating with a thickness of 50µm is prepared on the surface of the antioxidant layer through atmospheric plasma spraying. YTaO₄ spherical powder is first prepared through high-temperature solid-phase method by using Y₂O₃ and Ta₂O₅ as raw materials. Then, the YTaO₄ ceramic coating is prepared through atmospheric plasma spraying with the YTaO₄ spherical powder, and process parameters of the atmospheric plasma spraying are as follows: the spraying gun power is 42kW, and the spraying gun distance is 120mm, the gas flow rates of the argon and the hydrogen is 40/12slpm and 45/10slpm respectively, the feeding rate is 45g/min, the spraying gun rate is 200mm/s, and the spraying time is 2min.
**(4)A** heat-insulation cooling layer with the Y₃NbO₇ ceramic coating with the thickness of 80µmis prepared through atmospheric plasma spraying on the surface of the oxygen-blocking propagation layer. Y₃NbO₇ spherical powder is first prepared through the high-temperature solid-phase method by using Y₂O₃ and Nb₂O₅ as raw materials. Then, the Y₃NbO₇ ceramic coating is prepared through atmospheric plasma spraying with the Y₃NbO₇ spherical powder, and process parameters of the atmospheric plasma spraying are as follows: the spraying gun power is 43kW, and the spraying gun distance is 100mm, the gas flow rates of the argon and the hydrogen is 42/12slpm and 45/15slpm respectively, the feeding rate is 40g/min, the spraying gun rate is 100mm/s, and the spraying time is 3min.

### Embodiment 15:

Please refer to FIG. 4. In this embodiment, the lightweight material for manufacturing the UAV machine body is selected from TC4 titanium alloy material. The TC4 titanium alloy material is used as the matrix, the coating including "bonding layer, antioxidant layer, oxygen-blocking propagation layer and heat-insulation cooling layer" is prepared on a matrix surface, and the specific operations are as follows:
(1)the Zirconium-hafnium alloy (ZrHf) bonding layer with the thickness of 60µm is prepared on the surface of the TC4 titanium alloy through electron beam physical vapor deposition. In the process of the deposition, the substrate temperature is 400°C, the target-base distance is 300mm, the incident angle is 45°, the accelerating voltage of electrons is 22kV, the vacuum degree is less than 3×10⁻³Pa, and the deposition rate is 100nm/min.
(2)After a ZrHf coating is prepared, it is placed in the air and heated at 280°C for oxidation to obtain a ZrO₂/HfO₂ coating with a thickness less than 10µm, which means the antioxidant layer.
**(3)An** oxygen-blocking propagation layer of (Sm_{1/3}Yb_{1/3}Ho_{1/3})TaO₄ ceramic coating with a thickness of 50µm is prepared on the surface of the antioxidant layer through atmospheric plasma spraying. (Sm_{1/3}Yb_{1/3}Ho_{1/3})TaO₄ spherical powder is first prepared through high-temperature solid-phase method by using Ho₂O₃, Sm₂O₃, Yb₂O₃ and Ta₂O₅ as raw materials. Then, the (Sm_{1/3}Yb_{1/3}Ho_{1/3})TaO₄ ceramic coating is prepared through atmospheric plasma spraying with the (Sm_{1/3}Yb_{1/3}Ho_{1/3})TaO₄ spherical powder, and process parameters of the atmospheric plasma spraying are as follows: the spraying gun power is 42kW, and the spraying gun distance is 120mm, the gas flow rates of the argon and the hydrogen is 40/12slpm and 45/10slpm respectively, the feeding rate is 45g/min, the spraying gun rate is 200mm/s, and the spraying time is 2min.
**(4)A** heat-insulation cooling layer with the (Sm_{1/3}Yb_{1/3}Ho_{1/3})₃NbO₇ ceramic coating with a thickness of 250µm is prepared through atmospheric plasma spraying on the surface of the oxygen-blocking propagation layer. (Sm_{1/3}Yb_{1/3}Ho_{1/3})₃NbO₇ spherical powder is first prepared through the high-temperature solid-phase method by using Ho₂O₃, Sm₂O₃, Yb₂O₃ and Nb₂O₅ as raw materials. Then, the (Sm_{1/3}Yb_{1/3}Ho_{1/3})₃NbO₇ ceramic coating is prepared through atmospheric plasma spraying with the (Sm_{1/3}Yb_{1/3}Ho_{1/3})₃NbO₇ spherical powder, and process parameters of the atmospheric plasma spraying are as follows: the spraying gun power is 43kW, and the spraying gun distance is 100mm, the gas flow rates of the argon and the hydrogen is 42/12slpm and 45/15slpm respectively, the feeding rate is 40g/min, the spraying gun rate is 100mm/s, and the spraying time is 9min.

### Embodiment 16:

Please refer to FIG. 4. In this embodiment, the lightweight material for manufacturing the UAV machine body is selected from the carbon fiber braid. The carbon fiber braid is used as the matrix, the coating including "bonding layer, antioxidant layer, oxygen-blocking propagation layer and heat-insulation cooling layer" is prepared on the matrix surface, and the specific operations are as follows:
(1)the calcium-magnesium (CaMg) bonding layer with the thickness of 75µm is prepared on the surface of the carbon fiber braid through electron beam physical vapor deposition. In a process of the deposition, the substrate temperature is 350°C, the target-base distance is 300mm, the incident angle is 30°, the accelerating voltage of electrons is 20kV, the vacuum degree is less than 2×10⁻³Pa, and the deposition rate is 100nm/min.
(2)After a CaMg coating is prepared, it is placed in the air and heated at 120°C for oxidation to obtain a CaO/MgO coating with a thickness of 10µm, which means the antioxidant layer.
**(3)An** oxygen-blocking propagation layer of Yb_{1/4}Lu_{1/4}Y_{1/4}Sc_{1/4}TaO₄ ceramic coating with a thickness of 75µm is prepared on the surface of the antioxidant layer through atmospheric plasma spraying. Yb_{1/4}Lu_{1/4}Y_{1/4}Sc_{1/4}TaO₄ spherical powder is first prepared through high-temperature solid-phase method by using Yb₂O₃, Lu₂O₃, Y₂O₃, Sc₂O₃ and Ta₂O₅ as raw materials. Then, the Yb_{1/4}Lu_{1/4}Y_{1/4}Sc_{1/4}TaO₄ ceramic coating is prepared through atmospheric plasma spraying with the Yb_{1/4}Lu_{1/4}Y_{1/4}Sc_{1/4}TaO₄ spherical powder, and process parameters of the atmospheric plasma spraying are as follows: the spraying gun power is 42kW, and the spraying gun distance is 120mm, the gas flow rates of the argon and the hydrogen is 40/12slpm and 45/10slpm respectively, the feeding rate is 45g/min, the spraying gun rate is 200mm/s, and the spraying time is 3min.
**(4)A** heat-insulation cooling layer with (Yb_{1/4}Lu_{1/4}Y_{1/4}Sc_{1/4})₃NbO₇ ceramic coating with a thickness of 420µm is prepared through atmospheric plasma spraying on the surface of the oxygen-blocking propagation layer. (Yb_{1/4}Lu_{1/4}Y_{1/4}Sc_{1/4})₃NbO₇ spherical powder is first prepared through the high-temperature solid-phase method by using Yb₂O₃, Lu₂O₃, Y₂O₃, SC₂O₃ and Nb₂O₅ as raw materials. Then, the (Yb_{1/4}Lu_{1/4}Y_{1/4}Sc_{1/4})₃NbO₇ ceramic coating is prepared through atmospheric plasma spraying with the (Yb_{1/4}Lu_{1/4}Y_{1/4}Sc_{1/4})₃NbO₇ spherical powder, and process parameters of the atmospheric plasma spraying are as follows: the spraying gun power is 43kW, and the spraying gun distance is 120mm, the gas flow rates of the argon and the hydrogen is 42/12slpm and 45/15slpm respectively, the feeding rate is 50g/min, the spraying gun rate is 100mm/s, and the spraying time is 15min.

### Comparative embodiment 5:

The carbon fiber braid material is used as the matrix in this comparative embodiment, a coating including "bonding layer" is prepared on the matrix surface according to a method of the embodiment 11.

### Comparative embodiment 6:

The titanium alloy is used as the matrix in this comparative embodiment, a coating including "bonding layer and antioxidant layer" is prepared on the matrix surface according to the method of the embodiment 11.

### Comparative embodiment 7:

The carbon fiber braid material is used as the matrix in this comparative embodiment, a coating including "bonding layer, antioxidant layer and oxygen-blocking propagation layer" is prepared on the matrix surface according to the method of the embodiment 11.

Coating system structures of above-mentioned embodiments 11-16 and the comparative embodiments 5-7 and specific material compositions and thicknesses of each layer of coating are shown in Table 5. In order to detect protective and heat insulation effect of the surface coating including different material systems on lightweight materials, an ultimate working temperature (high temperature resistance performance), a corresponding heat insulation cooling gradient and an oxidation resistance are tested. A specific test process is to heat the surface of the material prepared with different coatings and observe a melting temperature of the material, thereby obtaining the high temperature resistance performance (ultimate working temperature) of the material. The temperature is kept at the ultimate working temperature for 60 seconds, and a temperature of a contact interface between the lightweight material and the coating is measured through a thermocouple. A temperature difference between the surface temperature and an interface temperature is the heat insulation cooling gradient. A mass of the material before and after the test is measured and the mass before and after the test are Z1 and Z2. Then an oxidation weight gain rate of the material is (Z2-Z1)/Z1×100%. The greater the weight gain rate, the worse its anti-oxidation performance. (A carbon fiber oxidation temperature used in the embodiment of the disclosure is 350°C, an ultimate working temperature of the aluminum alloy is 660°C, and an ultimate working temperature of the titanium alloy is 520°C.)

**Table 5**

| | matrix | bonding layer | antioxidant layer | oxygen-blocking propagation layer | reflective heat insulation layer |
|---|---|---|---|---|---|
| Embodiment 1 | carbon fiber | Si 50µm | SiO₂ | YbTaO₄ 50µm | La₃NbO₇ 300µm |
| Embodiment 2 | titanium alloy | Al 50µm | Al₂O₃ | Yb_{0.5}Lu_{0.5}TaO₄ 50µm | Y₃NbO₇ 350µm |
| Embodiment 3 | aluminum alloy | Al 20µm | Al₂O₃ | AlTaO₄ 100µm | Sm₃NbO₇ 600µm |
| Embodiment 4 | aluminum alloy | Ta 100µm | Ta₂O₅ | YTaO₄ 50µm | Y₃NbO₇ 80µm |
| Embodiment 5 | titanium alloy | ZrHf 60µm | ZrO₂/HfO₂ | (Sm_{1/3}Yb_{1/3}Ho_{1/3}) TaO₄ 50µm | (Sm_{1/3}Yb_{1/3}Ho_{1/3})₃NbO ₇ 250µm |
| Embodiment 6 | carbon fiber | CaMg 75µm | CaO/MgO | Yb_{1/4}Lu_{1/4}Y_{1/4}SC_{1/ 4}TaO₄ 75µm | (Yb_{1/4}Lu_{1/4}Y_{1/4}Sc_{1/4})₃N O₇ 420 µm |
| Comparative embodiment 1: | carbon fiber | Si 50µm | - | - | - |
| Comparative embodiment 2: | carbon fiber | Si 50µm | SiO₂ | - | - |
| Comparative embodiment 3: | carbon fiber | Si 50µm | SiO₂ | YbTaO₄ 20µm | - |

According to the above methods, the ultimate working temperatures, cooling gradients, oxidation weight gain rates and other properties of embodiments 11-16 and comparative embodiments 5-7 are respectively tested. The results are shown in Table 6 below:

**Table 6**

| | ultimate working temperature | cooling gradient | oxidation weight gain rate |
|---|---|---|---|
| Embodiment 1 | 520°C | 170°C | 3.3% |
| Embodiment 2 | 1106°C | 586°C | 1.5% |
| Embodiment 3 | 1270°C | 610°C | 1.0% |
| Embodiment 4 | 982°C | 322°C | 1.6% |
| Embodiment 5 | 967°C | 447°C | 5.6% |
| Embodiment 6 | 698°C | 348°C | 6.9% |
| Comparative embodiment 1: | 410°C | 60°C | -10.9% |
| Comparative embodiment 2: | 435°C | 85°C | -6.5% |
| Comparative embodiment 3: | 517°C | 167°C | -3.2% |

### Experimental results and analysis:

It may be seen from Table 6, in embodiments 11-16, after a complete coating system is prepared on the surface of the lightweight material matrix, the ultimate working temperature of the lightweight material has been greatly improved, and its thermal insulation and cooling effect is significant. Moreover, through adjusting the thickness of each coating, the heat insulation cooling gradient can be effectively controlled, so that the above-mentioned lightweight materials can be used for a long time at higher temperatures, and a resistance to high-temperature oxidative and ablation of the materials can be effectively improved. Comparing embodiment 11 with comparative embodiments 5-7, it may be seen that compared with comparative embodiments 5-7, the material of embodiment 11 has a higher ultimate working temperature, better thermal insulation and cooling effect, and stronger anti-oxidation ability. A material mass reduction in comparative embodiment 5 is very obvious, which is due to a mass reduction caused by an oxidation and sublimation of the carbon fiber. Material properties of comparative embodiment 6 are better than those of comparative embodiment 5, and material properties of comparative embodiment 7 are better than those of comparative embodiment 6, which indicates that settings of the oxygen-blocking propagation layer and the heat-insulation cooling layer can further improve the high temperature resistance, heat insulation and cooling capabilities, and oxidation resistance.

### Embodiment 17:

**Please** refer to FIG. 5. The disclosure further provides the UAV. The UAV includes the UAV machine body, the central control module 3, and an information acquisition module 1, a temperature detection module 2, a pressure control module 4, a UAV module 5 and an efficient fire protection module 6 respectively connected with the central control module 3.

**The** information acquisition module 1 is configured to obtain relevant information of a target fire extinguishing point including time of fire occurrence, fire location, fire type and fire estimation level, then form a first data set, and send the first data set to the central control module.

The temperature detection module 2 is configured to collect a temperature distribution of a fire scene to form a second data set, and send the second data set to the central control module.

The pressure control module 4 is configured to monitor a pressure state of an efficient fire extinguishing device and carry out a real-time control of the efficient fire extinguishing device.

**The** UAV machine body is made of lightweight material, and the lightweight material is selected from at least one of the carbon fiber braid, the titanium alloy and the aluminum alloy. The lightweight material is used as the matrix, and the method of the above-mentioned embodiment 11-16 is used to form the bonding layer, the antioxidant layer, the oxygen-blocking propagation layer and the heat insulation layer on the matrix in turn. Internal parts of the UAV and a lightweight material machine body are combined by ethylene propylene rubber. A specific production process is that the ethylene propylene rubber is covered on the surface of the UAV, and then the lightweight material casing of the UAV machine body may be buckled on its surface. Methods of embodiments 1-10 may also be used to form a coating on the resin-based composite matrix or the ceramic-based composite matrix, and then the matrix is arranged on the surface of the UAV machine body. The thickness of the bonding layer is from 20µm to 200µm, the thickness of the oxygen-blocking propagation layer is from 20µm to 100µm, the thickness of the heat-insulation cooling layer is from 80µmto 1000µm, and the thickness of the antioxidant layer is less than 20µm.

**Please** refer to FIG. 6. The UAV module 5 includes a remote controller, an aircraft power control device and a fire-extinguishing UAV. The remote controller is configured to control the fire-extinguishing UAV to perform a fire-extinguishing task issued by the central control module. The aircraft power control device is configured to provide flight power for the fire-extinguishing UAV, and the fire-extinguishing UAV is configured to perform the fire-extinguishing task to put out fires at target fire locations.

**The** efficient fire protection module 6 includes an efficient fire-extinguishing device and a safety helmet. The efficient fire-extinguishing device is configured to load efficient compressible foam fire extinguishing agent as fire-extinguishing raw materials to extinguish the fire scene, the efficient compressible foam fire extinguishing agent is non-toxic, harmless, and a reactant obtained by reacting with a combustion matter is also a non-toxic, harmless substance. The safety helmet is used to protect the efficient fire extinguishing device and includes an inner layer and an outer layer. The inner layer is made of a fire-resistant and explosion-proof polymer material, and the outer layer is made of corrosion-resistant material.

The central control module 3 includes a data storage unit 7, a task issuing unit 8 and an analysis processing unit 9. The data storage unit 7 is configured to store the first data set and the second data set. The task issuing unit is configured to issue the fire-extinguishing task to the UAV module according to the first data set. The analysis processing unit 9 is configured to analyze and process second data to obtain an analysis result of location information of a fire source and location information of a point before a fire spreading. A temperature changing spectrum is obtained according to a temperature detection situation, a detailed on-site temperature distribution is obtained in combination with a Beidou positioning system, specific positions of the fire source and the point before the fire spreading are found., and then a fire extinguishing is carried out according to a preset fire extinguishing strategy.

The temperature detection module is utilized to collect the temperature distribution of the target fire extinguishing point, and analyze the fire source and the specific point location information before the fire spreading.

**The** pressure control module is utilized to control the efficient fire protection module for a targeted fire extinguishing, first extinguish the fire at a point before the fire spreading, and then extinguish the fire source.

**The** UAV machine body further includes a load-bearing board, a stabilizing bracket, a balancing stabilizer and an aircraft propeller. The load-bearing board is configured to carry a UAV aircraft. The stabilizing bracket is configured to protect a safety of a fire extinguisher. The balancing stabilizer is configured to maintain the UAV aircraft in a balanced and stable state, and the aircraft propeller is configured to provide a flight lift for the UAV aircraft. Moreover, the aircraft propeller is woven from high-strength, low-quality carbon fiber, and a surface of the propeller is coated with a lightweight coating that is resistant to high temperatures.

**A** specific process of the embodiment is as follows:

First, the information acquisition module 1 obtains information of the target fire extinguishing point such as the time of fire occurrence, the fire location, the fire type and the fire estimation level, forms the first data set, and sends the first data set to the central control module.

**Second,** the data storage unit of the central control module 3 receives and stores the first data set and then the task issuing unit issues the fire-extinguishing task to the UAV module according to all of information of the first data set.

Third, after the remote controller of UAV module 5 receives the fire-extinguishing task, the fire-extinguishing UAV is controlled to begin to execute the fire-extinguishing task. Firstly, the aircraft power control device provides flight power for the fire-extinguishing UAV, and then the remote controller controls a flight distance and a flight attitude of the fire-extinguishing UAV, and controls the fire-extinguishing UAV to fly to the target fire extinguishing point from a fire-extinguishing center.

Fourth, the temperature detection module 2 begins to work, and collects the on-site temperature distribution of a fire scene and forms the second data set. Then the second data set is sent to the central control module, and the analysis processing unit of the central control module analyzes and processes the second data set, obtains the temperature changing spectrum according to the temperature detection situation, obtains the detailed on-site temperature distribution in combination with the Beidou positioning system, and finds a specific position of the fire source and the point before the fire spreads.

**Fifth,** the pressure control module 4 controls the efficient fire extinguishing device of the efficient fire protection module to spray the efficient compressible foam fire extinguishing agent to carry out a targeted fire extinguishing. First the fire is extinguished at the point before it spreads, and then the source of the fire is extinguished. After the fire extinguishing task is completed, the central control module 3 issues a returning control command, the fire-extinguishing UAV is controlled by the remote controller to fly back to the fire-extinguishing center, and the fire extinguishing task is over.

In recent years, research and application of rescue UAVs have not been in-depth and promoted, but they have been widely used in all aspects of society, especially in a field of firefighting, where UAVs are increasingly used. In recent years, fires have occurred frequently in southwest China, forest and grassland areas, the fires have come and developed rapidly, and the losses in areas with large areas of fire are more serious. The traditional fire extinguisher has a significant fire extinguishing effect for the fire of close range or small fire source, and is generally powerless for the fire of long distance and large fire. The fire-extinguishing UAV in the prior art, generally carries the fire extinguisher and flies to the fire location, sprays fire extinguishing agent to extinguish the fire in advance, which plays a role in containing fire in time. Compared with a fire brigade, an advantage is only that a fire extinguishing response speed is fast, and the UAVs can quickly arrive at the fire scene to extinguish the fire. However, its targeted fire extinguishing ability to the fire is not strong, a fire extinguishing effect is not good, and a whole fire extinguishing process is not intelligent and efficient enough.

While in the embodiment of the disclosure, it is not only intelligently issue fire-extinguishing task according to the information such as the time of fire occurrence, the fire location, the fire type, and the fire estimation level of the target fire extinguishing point, at the same time, after the fire-extinguishing UAV arrives at the fire scene, it is not directly unplanned to carry out fire extinguishing work, but also the fire-extinguishing UAV first detects the temperature distribution of the fire scene by the temperature detection module, obtains the temperature changing spectrum, obtains the detailed on-site temperature distribution in combination with the Beidou positioning system, and finds the specific locations of the fire source and the point before the fire spreads, and then carries out an efficient targeted and efficient fire extinguishing, which has better fire extinguishing effect, higher efficiency and more intelligence. The efficient compressible foam fire extinguishing agent used during fire extinguishing is non-toxic, harmless, and a reactant obtained by reacting with a combustion matter is also a non-toxic, harmless substance, which can effectively ensure a life safety of animals, evacuees and firefighters at the fire scene. A composition and structure of the UAV are made of high-temperature resistant materials, which can enable the fire-extinguishing UAV to continue to work in a high-temperature environment, and the fire-extinguishing UAV will not be deformed or burned, which further guarantees the fire-extinguishing effect.

### Embodiment 18:

This embodiment is basically the same as embodiment 17, and a difference is that: when the fire is larger, and a long-distance fire extinguishing effect is not significant, the temperature detection module detects a precise position of the fire source, and the UAV module is controlled by the remote controller to fly to the fire source. The pressure control module controls the efficient fire extinguishing device to blast, and the fire source is blasted and extinguished at a fixed point at a fixed time, so that the fire is quickly controlled.

**A** specific process of this embodiment is the same as that of embodiment 17, with the following differences:
Fifth, the pressure control module 4 controls the efficient fire extinguishing device of the efficient fire protection module to spray the efficient compressible foam fire extinguishing agent to carry out a targeted fire extinguishing. First the fire is extinguished at the point before it spreads, and then the source of the fire is extinguished. If the long-distance fire extinguishing effect is not significant, the fire is still gradually increasing, the temperature detection module detects the precise position of the fire source, and then the remote controller controls the UAV module to fly to the fire source. The pressure control module controls the efficient fire extinguishing device for blasting, and the fire source is blasted and extinguished at the fixed point at the fixed time, so as to quickly control the fire. Then a backup fire-extinguishing UAV will be dispatched to continue extinguishing the remaining fires until all open flames are extinguished and the fire-extinguishing task is over.

When the fire extinguishing UAV is carrying out the long-distance fire extinguishing, if there is an emergency, such as a sudden increase in wind volume causes the fire to gradually increase, and the fire cannot be controlled by the long-distance fire extinguishing, a blasting fire extinguishing is directly used to quickly and efficiently extinguish the fire source, so as to avoid more serious losses caused by a continued expansion of the fire. Although blasting and extinguishing will lose the fire-extinguishing UAV, it can control an out-of-control fire in time, reduce an impact of the fire, and ensure the safety of the evacuees and firefighters. Its value is still greater than its economic value of a fire-extinguishing UAV itself.

### Embodiment 19:

This embodiment is basically the same as embodiment 17, and a difference is that: after the fire-extinguishing UAV completes the fire-extinguishing task and extinguishes all the open flames at the fire scene, the temperature detection module collects the temperature distribution of the scene again, and determines a point with a temperature greater than 60°C as a re-ignition point where the fire may re-ignite, and then the fire-extinguishing UAV carries out the targeted fire extinguishing on these re-ignition points one by one until its temperature is reduced to below 40°C.

**A** specific process of this embodiment is the same as that of embodiment 17, with the following differences:
Fifth, the pressure control module 4 controls the efficient fire extinguishing device of the efficient fire protection module to spray the efficient compressible foam fire extinguishing agent to carry out a targeted fire extinguishing. First the fire is extinguished at the point before it spreads, and then the source of the fire is extinguished. After the fire extinguishing task is completed, the temperature detection module collects the temperature distribution of the scene again, and determines the point with the temperature greater than 60°C as the re-ignition point where the fire may re-ignite. The remote controller of the UAV module 5 controls the fire-extinguishing UAV to fly one by one to 2 meters directly above these re-ignition points, and then the fire-extinguishing UAV carries out the targeted fire extinguishing on these re-ignition points one by one until its temperature is reduced to below 40°C. Finally, the central control module 3 issues a returning control command, the fire-extinguishing UAV is controlled by the remote controller to fly back to the fire-extinguishing center, and the fire extinguishing task is over.

Combined with an actual situation, in many cases such as a mountain fire or a forest fire, soon after the open flames are extinguished, there will be a re-ignition phenomenon. Therefore, after the fire-extinguishing UAV extinguishes all the open flames, the temperature detection module detects all the points where the temperature is higher than 60°C, and a secondary fire extinguishing is carried out to avoid the re-ignition phenomenon which may cause more serious losses. At the same time, it can also effectively improve the fire extinguishing effect of the fire-extinguishing UAV.

### Embodiment 20:

This embodiment is basically the same as embodiment 17, and a difference is that: an intelligent fire-extinguishing UAV system further includes a display module, configured to display the fire extinguishing on-site scene and remaining power of the fire extinguishing UAV in real time.

**A** specific process of this embodiment is the same as that of embodiment 17, with the following differences:
**Fifth,** the pressure control module 4 controls the efficient fire extinguishing device of the efficient fire protection module to spray the efficient compressible foam fire extinguishing agent to carry out a targeted fire extinguishing. First the fire is extinguished at the point before it spreads, and then the source of the fire is extinguished. During a fire extinguishing process, the display module can display a fire extinguishing on-site scene and remaining power of the fire extinguishing UAV in real time. After the fire extinguishing task is completed, the central control module issues a returning control command, the fire-extinguishing UAV is controlled by the remote controller to fly back to the fire-extinguishing center, and the fire extinguishing task is over.

Through the display module, the fire extinguishing on-site scene can be viewed in real time, so that a staff can clearly understand a fire extinguishing progress and the fire extinguishing effect. If there is an emergency, they can also take timely countermeasures, and at the same time can check the remaining power of the fire-extinguishing UAV, so as to recall the fire-extinguishing UAV in time when the power is about to run out, which avoids the UAV from crashing due to loss of power.

## Claims

1. A **UAV** surface coating, at least comprising: a bonding layer, an antioxidant layer, an oxygen-blocking propagation layer and a heat-insulation cooling layer; wherein
the coating is configured to be fabricated on a surface of a UAV machine body or configured to be covered on the surface of the UAV machine body through a composite material matrix;
the UAV machine body is made of lightweight material;
the composite material matrix includes a resin-based composite matrix and a ceramic-based composite matrix, wherein, a thickness of the bonding layer is from 20µm to 200µm, a thickness of the oxygen-blocking propagation layer is from 20µm to 200µm, and a thickness of the heat-insulation cooling layer is from 80µmto 1000µm;
the lightweight material is selected from at least one of carbon fiber braid, titanium alloy and aluminum alloy, and internal parts of the UAV are bonded to the lightweight material through ethylene propylene rubber;
the resin-based composite matrix is a fiber-reinforced material with an organic polymer as matrix, and the fiber-reinforced material is one of glass fiber, carbon fiber, basalt fiber and aramid fiber;
the ceramic-based composite matrix is one of silicon carbide fiber-reinforced silicon carbide, carbon fiber-reinforced carbon, carbon fiber-reinforced silicon carbide and silicon carbide fiber-reinforced carbon;
a raw material of the bonding layer is a material with a thermal expansion coefficient similar to that of the lightweight material, and the raw material of the bonding layer is selected from at least one of aluminum, iron, magnesium, calcium, silicon, tantalum, vanadium, yttrium, zirconium, hafnium, niobium, molybdenum and tungsten;
the antioxidant layer is one of Al₂O₃, SiO₂, Ta₂O₅, Nb₂O₅, ZrO₂, Mo₂O₅ and WO₃, or a combination thereof;
the oxygen-blocking propagation layer is a rare earth tantalate ceramic material, or a rare earth tantalum/niobate ceramic material; and
the heat-insulation cooling layer is a rare earth niobate ceramic material, or a rare earth tantalate ceramic material, or a rare earth tantalum/niobate ceramic material.

2. The UAV surface coating according to claim 1, wherein, a thermal expansion coefficient buffer layer is provided between the oxygen-blocking propagation layer and the heat-insulation cooling layer on the ceramic-based composite matrix, and a thickness of the thermal expansion coefficient buffer layer is from 30µm to 50µm.

3. The UAV surface coating according to claim 2, wherein, a thermal expansion coefficient of the oxygen-blocking propagation layer is between 3×10⁻⁶ K⁻¹ and 6×10⁻⁶ K, a thermal expansion coefficient of the thermal expansion coefficient buffer layer is between 6×10⁻⁶ K⁻¹ and 9××10⁻⁶ K⁻¹, and a thermal expansion coefficient of the heat-insulation cooling layer is between 9×10⁻⁶ K⁻¹ and 11×10⁻⁶ K⁻¹.

4. The UAV surface coating according to claim 2, wherein, the thermal expansion coefficient buffer layer is a ceramic of RETa₃O₉, wherein RE is composed of one or more rare earth elements.

5. The UAV surface coating according to claim 1, wherein, the rare earth tantalate ceramic material is spherical powder of ATaO₄, and A is Al, Fe or the rare earth element; the rare earth tantalum/niobate ceramic is a ceramic material of RETa₁₋ₓNbₓO₄, wherein
RE is one or more of the rare earth elements, and 0<x<1.

6. The UAV surface coating according to claim 1, wherein, the rare earth niobate ceramic material is spherical powder of RE₃NbO₇,
the rare earth tantalate ceramic is ceramic of RE₃TaO₇,
the rare earth tantalum/niobate ceramic is RE₃Ta_{1-y}Nb_{y}O₇, wherein RE is one or more of the rare earth elements, and 0<x<1.

7. A preparation method of the UAV surface coating according to claim 1, comprising:
preparing a bonding layer on an upper surface of a ceramic-based composite matrix through cold spraying, or preparing the bonding layer on a surface of a resin-based composite matrix or on a surface of UAV machine body through electron beam physical vapor deposition;
placing the bonding layer in air for oxidation to form an antioxidant layer;
preparing an oxygen-blocking propagation layer on a surface of the antioxidant layer through atmospheric plasma spraying;
preparing a heat-insulation cooling layer on a surface of the oxygen-blocking propagation layer through atmospheric plasma spraying.

8. The preparation method of the UAV surface coating according to claim 7, wherein, preparing the heat-insulation cooling layer on the surface of the oxygen-blocking propagation layer through atmospheric plasma spraying on the ceramic-based composite matrix further comprises:
preparing a thermal expansion coefficient buffer layer on the surface of the oxygen-blocking propagation layer through atmospheric plasma spraying;
preparing the heat-insulation cooling layer on a surface of the thermal expansion coefficient buffer layer through atmospheric plasma spraying.

## Patentansprüche

1. Oberflächenbeschichtung für ein unbemanntes Luftfahrzeug (UAV), mindestens umfassend: eine Haftschicht, eine Antioxidationsschicht, eine Sauerstoffausbreitungssperrschicht und eine Wärmedämm- und Kühlschicht, wobei die Beschichtung dazu eingerichtet ist, auf einer Oberfläche eines UAV-Flugkörperaufbaus hergestellt zu werden oder über eine Verbundwerkstoffmatrix auf der Oberfläche des UAV-Flugkörperaufbaus aufgebracht zu werden;
der UAV-Flugkörperaufbau aus einem Leichtbaumaterial hergestellt ist;
die Verbundwerkstoffmatrix eine harzbasierte Verbundwerkstoffmatrix und eine keramikbasierte Verbundwerkstoffmatrix umfasst, wobei eine Dicke der Haftschicht von 20µm bis 200µm beträgt, eine Dicke der Sauerstoffausbreitungssperrschicht von 20µm bis 200µm beträgt und eine Dicke der Wärmedämm- und Kühlschicht von 80µm bis 1000µm beträgt;
das Leichtbaumaterial mindestens ein Material ist, das aus Kohlenstofffasergeflecht, Titanlegierung und Aluminiumlegierung ausgewählt ist, und innere Teile des UAV mittels Ethylen-Propylen-Kautschuk mit dem Leichtbaumaterial verbunden sind;
die harzbasierte Verbundwerkstoffmatrix ein faserverstärkter Werkstoff mit einem organischen Polymer als Matrix ist, und der faserverstärkte Werkstoff eines der folgenden Materialien ist: Glasfaser, Kohlenstofffaser, Basaltfaser und Aramidfaser;
die keramikbasierte Verbundwerkstoffmatrix einer der folgenden Werkstoffe ist:
siliziumcarbidfaserverstärktes Siliziumcarbid, kohlenstofffaserverstärkter Kohlenstoff, kohlenstofffaserverstärktes Siliziumcarbid und siliziumcarbidfaserverstärkter Kohlenstoff;
ein Ausgangsmaterial der Haftschicht ein Material mit einem Wärmeausdehnungskoeffizienten ist, der demjenigen des Leichtbaumaterials ähnlich ist, und das Ausgangsmaterial der Haftschicht mindestens ein Material ist, das aus Aluminium, Eisen, Magnesium, Calcium, Silizium, Tantal, Vanadium, Yttrium, Zirconium, Hafnium, Niob, Molybdän und Wolfram ausgewählt ist;
die Antioxidationsschicht eines der folgenden Materialien oder eine Kombination davon ist: Al₂O₃, SiO₂, Ta₂O₅, Nb₂O₅, ZrO₂, Mo₂O₅ und WO₃;
die Sauerstoffausbreitungssperrschicht ein Seltenerdtantalat-Keramikmaterial oder ein Seltenerdtantalat/niobat-Keramikmaterial ist; und
die Wärmedämm- und Kühlschicht ein Seltenerdniobat-Keramikmaterial oder ein Seltenerdtantalat-Keramikmaterial oder ein Seltenerdtantalat/niobat-Keramikmaterial ist.

2. Oberflächenbeschichtung für ein UAV nach Anspruch 1, wobei eine Wärmeausdehnungskoeffizienten-Pufferschicht zwischen der Sauerstoffausbreitungssperrschicht und der Wärmedämm- und Kühlschicht auf der keramikbasierten Verbundwerkstoffmatrix vorgesehen ist und eine Dicke der Wärmeausdehnungskoeffizienten-Pufferschicht von 30µm bis 50µm beträgt.

3. Oberflächenbeschichtung für ein UAV nach Anspruch 2, wobei ein Wärmeausdehnungskoeffizient der Sauerstoffausbreitungssperrschicht zwischen 3×10⁻⁶ K⁻¹ und 6×10⁻⁶ K⁻¹ liegt,
ein Wärmeausdehnungskoeffizient der Wärmeausdehnungskoeffizienten-Pufferschicht zwischen 6×10⁻⁶ K⁻¹ und 9×10⁻⁶ K⁻¹ liegt
und ein Wärmeausdehnungskoeffizient der Wärmedämm- und Kühlschicht zwischen 9×10⁻⁶ K⁻¹ und 11×10⁻⁶ K⁻¹ liegt.

4. Oberflächenbeschichtung für ein UAV nach Anspruch 2, wobei die Wärmeausdehnungskoeffizienten-Pufferschicht eine Keramik aus RETa₃O₉ ist, wobei RE für ein oder mehrere Seltenerdelemente steht.

5. Oberflächenbeschichtung für ein UAV nach Anspruch 1, wobei das Seltenerdtantalat-Keramikmaterial kugelförmiges Pulver aus ATaO₄ ist, und A für Al, Fe oder das Seltenerdelement steht; wobei die Seltenerdtantalat/niobat-Keramik ein Keramikmaterial aus RETa₁₋ₓNbₓO₄ ist, wobei RE für eines oder mehrere der Seltenerdelemente steht und 0<x<1 gilt.

6. Oberflächenbeschichtung für ein UAV nach Anspruch 1, wobei das Seltenerdniobat-Keramikmaterial kugelförmiges Pulver aus RE₃NbO₇ ist;
wobei die Seltenerdtantalat-Keramik eine Keramik aus RE₃TaO₇ ist;
wobei die Seltenerdtantalat/niobat-Keramik RE₃Ta_{1-y}Nb_{y}O₇ ist,
wobei RE für eines oder mehrere der Seltenerdelemente steht und 0<_{y}<1 gilt.

7. Verfahren zur Herstellung der Oberflächenbeschichtung für ein UAV nach Anspruch 1, umfassend:
Herstellen einer Haftschicht auf einer oberen Oberfläche einer keramikbasierten Verbundwerkstoffmatrix mittels Kaltgasspritzen oder Herstellen der Haftschicht auf einer Oberfläche einer harzbasierten Verbundwerkstoffmatrix oder auf einer Oberfläche eines UAV-Flugkörperaufbaus durch physikalische Gasphasenabscheidung mittels eines Elektronenstrahls;
Einbringen der Haftschicht in eine Luftumgebung zur Oxidation, um eine Antioxidationsschicht zu bilden;
Herstellen einer Sauerstoffausbreitungssperrschicht auf einer Oberfläche der Antioxidationsschicht mittels atmosphärischen Plasmaspritzens;
Herstellen einer Wärmedämm- und Kühlschicht auf einer Oberfläche der Sauerstoffausbreitungssperrschicht mittels atmosphärischen Plasmaspritzens.

8. Verfahren nach Anspruch 7 zur Herstellung der Oberflächenbeschichtung für ein UAV, wobei das Herstellen der Wärmedämm- und Kühlschicht auf der Oberfläche der Sauerstoffausbreitungssperrschicht mittels atmosphärischen Plasmaspritzens auf der keramikbasierten Verbundwerkstoffmatrix ferner umfasst:
Herstellen einer Wärmeausdehnungskoeffizienten-Pufferschicht auf der Oberfläche der Sauerstoffausbreitungssperrschicht mittels atmosphärischen Plasmaspritzens;
Herstellen der Wärmedämm- und Kühlschicht auf einer Oberfläche der Wärmeausdehnungskoeffizienten-Pufferschicht mittels atmosphärischen Plasmaspritzens.

## Revendications

1. Un revêtement de surface de drone, comprenant au moins : une couche de liaison, une couche antioxydante, une couche de blocage de la propagation de l'oxygène et une couche de refroidissement et d'isolation thermique ; dans lequel
le revêtement est configuré pour être fabriqué sur une surface d'un corps de drone ou configuré pour être recouvert sur la surface du corps de drone par l'intermédiaire d'une matrice en matériau composite ;
le corps de drone est fait d'un matériau léger ;
la matrice en matériau composite comprend une matrice composite à base de résine et une matrice composite à base de céramique, dans lequel, une épaisseur de la couche de liaison est comprise entre 20 µm et 200 µm, une épaisseur de la couche de blocage de la propagation de l'oxygène est comprise entre 20 µm et 200 µm, et une épaisseur de la couche de refroidissement et d'isolation thermique est comprise entre 80 µm et 1 000 µm ;
le matériau léger est choisi parmi au moins l'un d'une tresse en fibre de carbone, d'un alliage de titane et d'un alliage d'aluminium, et des parties internes du drone sont liées au matériau léger par l'intermédiaire de caoutchouc éthylène-propylène ;
la matrice composite à base de résine est un matériau renforcé de fibres avec un polymère organique comme matrice, et le matériau renforcé de fibres est l'un parmi la fibre de verre, la fibre de carbone, la fibre de basalte et la fibre d'aramide ;
la matrice composite à base de céramique est l'un parmi le carbure de silicium renforcé de fibres de carbure de silicium, le carbone renforcé de fibres de carbone, le carbure de silicium renforcé de fibres de carbone et le carbone renforcé de fibres de carbure de silicium ;
une matière première de la couche de liaison est un matériau ayant un coefficient de dilatation thermique similaire à celui du matériau léger, et la matière première de la couche de liaison est choisie parmi au moins l'un de l'aluminium, du fer, du magnésium, du calcium, du silicium, du tantale, du vanadium, de l'yttrium, du zirconium, du hafnium, du niobium, du molybdène et du tungstène ;
la couche antioxydante est l'un de Al₂O₃, SiO₂, Ta₂O₅, Nb₂O₅, ZrO₂, Mo₂O₅ et WO₃, ou une combinaison de ceux-ci ;
la couche de blocage de la propagation de l'oxygène est un matériau céramique au tantalate de terre rare, ou un matériau céramique au tantale/niobate de terre rare ; et
la couche de refroidissement et d'isolation thermique est un matériau céramique au niobate de terre rare, ou un matériau céramique au tantalate de terre rare, ou un matériau céramique au tantale/niobate de terre rare.

2. Revêtement de surface de drone selon la revendication 1, dans lequel, une couche tampon de coefficient de dilatation thermique est prévue entre la couche de blocage de la propagation de l'oxygène et la couche de refroidissement et d'isolation thermique sur la matrice composite à base de céramique, et une épaisseur de la couche tampon de coefficient de dilatation thermique est comprise entre 30 µm et 50 µm.

3. Revêtement de surface de drone selon la revendication 2, dans lequel, un coefficient de dilatation thermique de la couche de blocage de la propagation de l'oxygène est compris entre 3×10⁻⁶ K⁻¹ et 6×10⁻⁶ K⁻¹, un coefficient de dilatation thermique de la couche tampon de coefficient de dilatation thermique est compris entre 6×10⁻⁶ K⁻¹ et 9×10⁻⁶ K⁻¹, et un coefficient de dilatation thermique de la couche de refroidissement et d'isolation thermique est compris entre 9×10⁻⁶ K⁻¹ et 11×10⁻⁶ K⁻¹.

4. Revêtement de surface de drone selon la revendication 2, dans lequel, la couche tampon de coefficient de dilatation thermique est une céramique de RETa₃O₉, dans lequel RE est composé d'un ou plusieurs éléments de terre rare.

5. Revêtement de surface de drone selon la revendication 1, dans lequel, le matériau céramique au tantalate de terre rare est une poudre sphérique d'ATaO₄, et A est Al, Fe ou l'élément de terre rare ;
la céramique au tantale/niobate de terre rare est un matériau céramique de RETa₁₋ₓNbₓO₄, dans lequel RE est un ou plusieurs des éléments de terre rare, et 0<x<1.

6. Revêtement de surface de drone selon la revendication 1, dans lequel, le matériau céramique au niobate de terre rare est une poudre sphérique de RE₃NbO₇ ;
la céramique au tantalate de terre rare est une céramique de RE₃TaO₇ ;
la céramique au tantale/niobate de terre rare est RE₃Ta₁-_{y}Nb_{y}O₇, dans laquelle RE est un ou plusieurs des éléments de terre rare, et 0<y<1.

7. Méthode de préparation du revêtement de surface de drone selon la revendication 1, comprenant :
la préparation d'une couche de liaison sur une surface supérieure d'une matrice composite à base de céramique par projection à froid, ou la préparation de la couche de liaison sur une surface d'une matrice composite à base de résine ou sur une surface du corps de drone par dépôt physique en phase vapeur par faisceau d'électrons ;
le placement de la couche de liaison à l'air pour oxydation afin de former une couche antioxydante ;
la préparation d'une couche de blocage de la propagation de l'oxygène sur une surface de la couche antioxydante par projection par plasma atmosphérique ;
la préparation d'une couche de refroidissement et d'isolation thermique sur une surface de la couche de blocage de la propagation de l'oxygène par projection par plasma atmosphérique.

8. Méthode de préparation du revêtement de surface de drone selon la revendication 7, dans laquelle, la préparation de la couche de refroidissement et d'isolation thermique sur la surface de la couche de blocage de la propagation de l'oxygène par projection par plasma atmosphérique sur la matrice composite à base de céramique comprend en outre :
la préparation d'une couche tampon de coefficient de dilatation thermique sur la surface de la couche de blocage de la propagation de l'oxygène par projection par plasma atmosphérique ;
la préparation de la couche de refroidissement et d'isolation thermique sur une surface de la couche tampon de coefficient de dilatation thermique par projection par plasma atmosphérique.
